(19) Europäisches Patentamt
European Patent Office
Office européen des brevets

(11) EP 2 249 430 A1

(12) **EUROPEAN PATENT APPLICATION**
published in accordance with Art. 153(4) EPC

(43) Date of publication:
**10.11.2010 Bulletin 2010/45**

(21) Application number: **09717189.6**

(22) Date of filing: **07.03.2009**

(51) Int Cl.:
*H01M 14/00* (2006.01) *C01G 23/04* (2006.01)
*C09B 23/00* (2006.01) *C09B 57/00* (2006.01)
*C09B 67/02* (2006.01) *H01L 31/04* (2006.01)

(86) International application number:
**PCT/JP2009/054345**

(87) International publication number:
**WO 2009/110618 (11.09.2009 Gazette 2009/37)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **07.03.2008 JP 2008058818**

(71) Applicants:
- **The University of Tokyo Bunkyo-Ku Tokyo 113-8654 (JP)**
- **Nippon Oil Corporation Tokyo 105-8412 (JP)**

(72) Inventors:
- **SEGAWA, Hiroshi Tokyo 113-8654 (JP)**
- **FUJISAWA, Jun-ichi Tokyo 113-8654 (JP)**
- **KUBO, Takaya Tokyo 113-8654 (JP)**
- **UCHIDA, Satoshi Tokyo 113-8654 (JP)**

(74) Representative: **Hards & Franke Patentanwälte Partnerschaft Widenmayerstraße 25 D-80538 München (DE)**

# (54) COMPOSITE MATERIAL, PHOTOELECTRIC CONVERSION MATERIAL, DYE-SENSITIZED SOLAR CELL, DYE-SENSITIZED SOLAR CELL DEVICE, MANUFACTURING METHOD FOR PHOTOELECTRIC CONVERSION DEVICE, AND METHOD OF ANALYZING OXYGEN TITANIUM CRYSTAL STRUCTURE

(57) There is provided a hybrid and/or complex material or the like which can realize a high-efficient photoelectric conversion material or the like. One aspect of the present invention lies in a dye-sensitized solar cell device 10, **characterized by** including: a first substrate 11;, a first conductive layer 12 formed on the first substrate; a Pt catalyst layer formed on the first conductive layer; an electrolyte layer 13 formed on the Pt catalyst layer; a dye-adsorbed metal oxide layer 14 formed on the electrolyte layer in which 7, 7, 8, 8-tetracyanoquinodimethane is adsorbed to an anatase type titanium oxide; a second conductive layer 15 formed on the dye-adsorbed metal oxide layer; and a second substrate 16 formed on the second conductive layer. According to this composition above, there is obtained a high-efficient dye-sensitized solar cell device in which light can be converted efficiently over wide wavelengths.

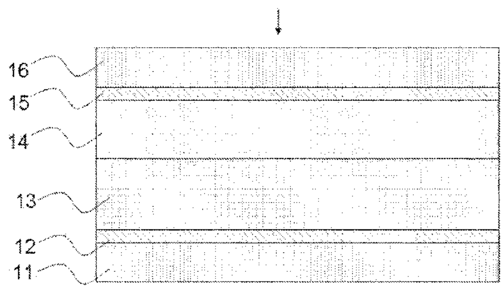


Fig. 1



Printed by Jouve, 75001 PARIS (FR)

## Description

### TECHNICAL FIELD

The present invention relates to a hybrid and/or complex material and particularly relates to a photoelectric conversion material, a dye-sensitized solar cell, a dye-sensitized solar cell device, a manufacturing method of a photoelectric conversion device, and a method of analyzing titanium oxide crystal structure.

### BACKGROUND ART

For the production of an organic-based solar cell, it is possible to use a raw material of low cost without using high vacuum and/or high temperature processes frequently and therefore, as a low cost solar cell for being used in the photovoltaic power generation and eventually, for being used in the next generation, a so-called Gratzel type (wet type) dye-sensitized solar cell attracts attention particularly.

The Gratzel type dye-sensitized solar cell has a structure in which there are provided a photoelectric conversion electrode formed by being adsorbed with dye in a metal nanoparticles layer of titanium oxide or the like which is sintered on a transparent conductive substrate and a counter electrode composed of a conductive substrate formed with a thin film of Pt or a carbon material, and an electrolyte layer including a redox couple of iodine or the like is sandwiched by those electrodes. The photoelectric conversion efficiency of this dye-sensitized solar cell depends largely on sun light absorption ability of the dye. In the Gratzel type dye-sensitized solar cell, it has been reported as 11% (1cm square size) which is the highest photoelectric conversion efficiency for an organic-based solar cell, but further promotion for high efficiency is necessary toward the practical use.

Also, Ru metal complex used in this Gratzel type dye-sensitized solar cell includes Ru which is a rare metal, so that development of dye of high performance and also of low cost has been desired. Generally, there is used a method of chemically adsorbing dye by utilizing an OH group on the surface of the metal oxide of titanium oxide or the like, so that it becomes necessary for the dye to introduce a functional group called such as a COOH group, a POOH group and the like and the dye synthesizing steps will increase, so that there was also a case in which the increase of the synthesizing cost was triggered.

With respect to the solar cell, considerable research has been already done, but as mentioned above, there were still a lot of obstacles to be overcome for further commercialization.

Non-patent Document 1: B. W. Smucker, J. M. Hudson, M. A. Omary, and K. R. Dunbr, Inorganic Chemistry, 42, 4714 (2003).

### DISCLOSURE OF THE INVENTION

#### Problem to be solved by the Invention

The present invention was invented in view of the background art mentioned above and has an object for providing a hybrid and/or complex material or the like which can realize a high-efficient photoelectric conversion material or the like.

#### Means for solving the Problem

According to this invention, in order to achieve the object mentioned above, there are employed the compositions as described in the scope of the appended claims. Hereinafter, this invention will be explained in detail.

A first aspect of the present invention lies, in a hybrid and/or complex material in which a compound or its reductant expressed by any one of general formulas from (1) to (13C) mentioned below is adsorbed to a metal oxide, in a hybrid and/or complex material, **characterized in that** absorption can be observed in a region of wavelengths different from absorption spectrum that is observed in a region from ultraviolet ray to near-infrared ray presented by aforesaid compound which is not adsorbed to aforesaid metal oxide.

[Chemical Formula 1]

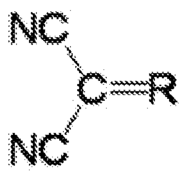

(1)

[In the formula, R denotes a fatty series group, an aromatic group or a heterocyclic group.]

[Chemical Formula 2]

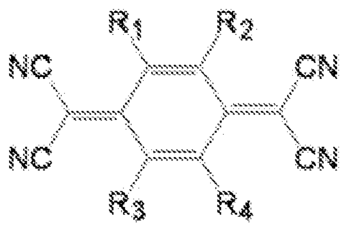

(2)

[In the formula, R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 3]

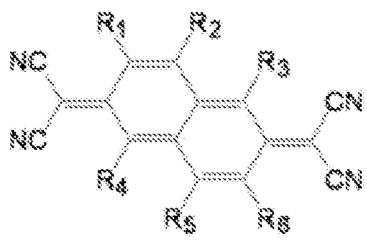

(3)

[In the formula, R1 to R6 may be the same or different one another and any one thereof denotes one of a hydrogen atom, a fatty series group, an aromatic group, a heterocyclic group and a halogen group in which any one of those may be substituted by a substituent group.]

[Chemical Formula 4]

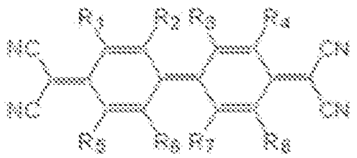

(4)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 5]

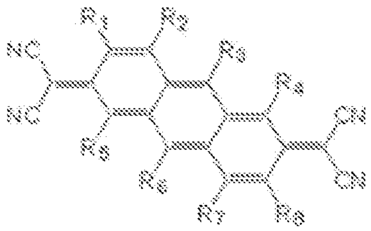

(5)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 6]

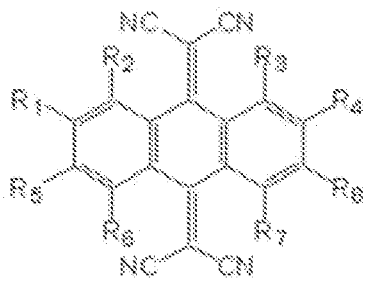

(6)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 7]

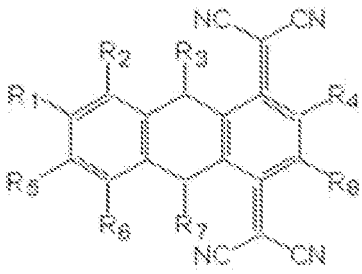

(7)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 8]

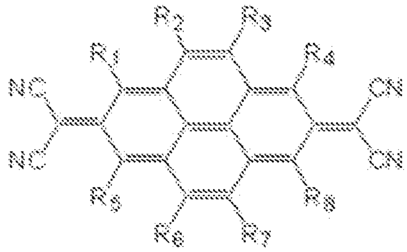

(8)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 9]

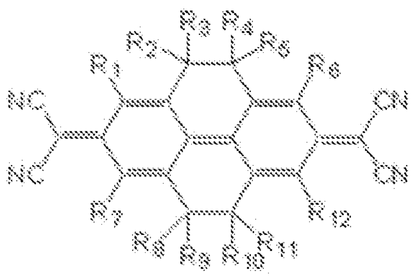

(9)

[R1 to R12 may be the same or different one another and any one thereof denotes one of a hydrogen atom, a fatty series group, an aromatic group, a heterocyclic group and a halogen group in which any one of those may be substituted by a substituent group.]

[Chemical Formula 10]

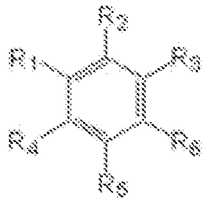

(10)

[R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 11]

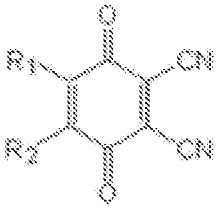

(11)

[R1, R2 may be the same or different mutually and any one thereof denotes one of a hydrogen atom, a fatty series group, an aromatic group, a heterocyclic group and a halogen group in which any one of those may be substituted by a substituent group.]

[Chemical Formula 12]

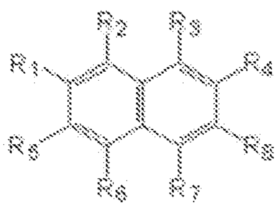

(12)

[R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13]

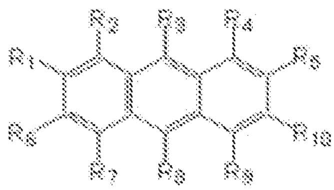

(13)

[R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13A]

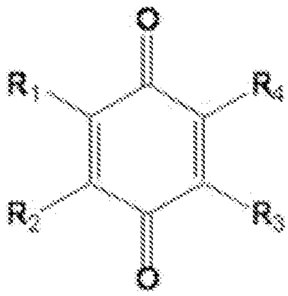

(13A)

[R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 13B]

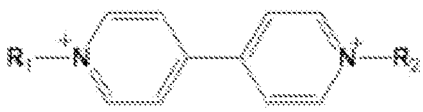

(13B)

[R1, R2 may be the same or different mutually and any one thereof denotes one of a hydrogen atom, a fatty series group, an aromatic group, a heterocyclic group and a halogen group in which any one of those may be substituted by a substituent group.]

$C_{60}$ (13C)

[$C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.]

According to this composition above, there is obtained a hybrid and/or complex material which can realize a high-efficient photoelectric conversion material or the like.

A second aspect of the present invention lies in the hybrid and/or complex material according to claim 1, **characterized in that** each of the carbon number of the fatty series group of the substituent group, the carbon number

of the aromatic group and the carbon number of the heterocyclic group in the general formulas from (1) to (13C) is 30 or less.

A third aspect of the present invention lies in a hybrid and/or complex material, **characterized in that** a compound or its reductant expressed by any one of formulas from (i) to (xvi) mentioned below is adsorbed to a metal oxide.

[Chemical Formulas 14]

(i) 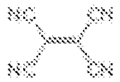
(v) 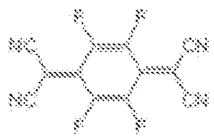
(ix) 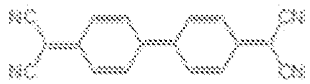
(ii) 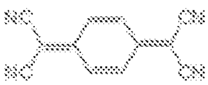
(vi) 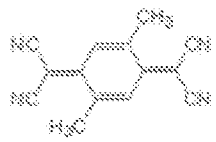
(x) 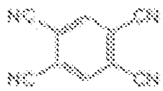
(iii) 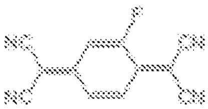
(vii) 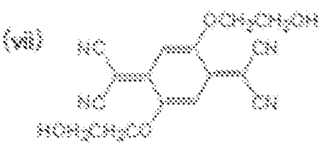
(xi) 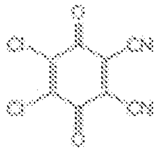
(iv) 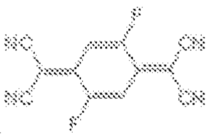
(viii) 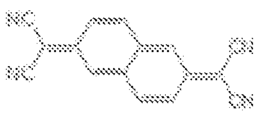
(xii) 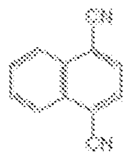
(xiii) 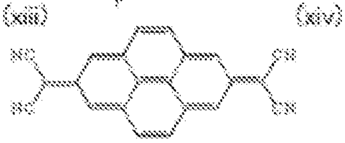
(xiv) 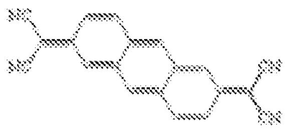
(xv) 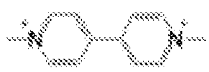
(xvi) 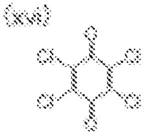

According to this composition above, there is obtained a hybrid and/or complex material which can realize a high-efficient photoelectric conversion material or the like.

A fourth aspect of the present invention lies in a hybrid and/or complex material, **characterized in that** a compound or its reductant expressed by any one of formulas from (a) to (f) mentioned below is adsorbed to a metal oxide.

[Chemical Formulas 15]

(a) 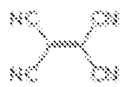
(c) 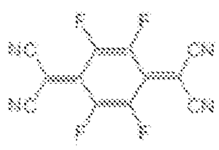
(e) 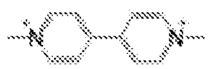
(b) 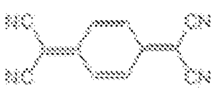
(d) 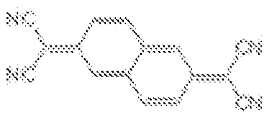
(f) 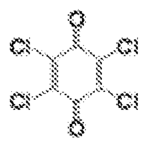

According to this composition above, there is obtained a hybrid and/or complex material which can realize a high-efficient photoelectric conversion material or the like.

A fifth aspect of the present invention lies in the hybrid and/or complex material according to claim 1, **characterized in that** aforesaid metal oxide is a titanium oxide.

According to this composition above, there is obtained a hybrid and/or complex material which can realize a high-efficient photoelectric conversion material or the like.

A sixth aspect of the present invention lies in the hybrid and/or complex material according to claim 1, **characterized in that** aforesaid metal oxide is an anatase type titanium oxide.

According to this composition above, there is obtained a hybrid and/or complex material which can realize a high-efficient photoelectric conversion material or the like in which light can be converted efficiently over wide wavelengths.

A seventh aspect of the present invention lies, in a hybrid and/or complex material in which a compound or its reductant expressed by any one of general formulas from (1) to (13C) mentioned below is adsorbed to a semiconductor, in a hybrid and/or complex material, **characterized in that** absorption can be observed in a region of wavelengths different from absorption spectrum that is observed in a region from ultraviolet ray to near-infrared ray presented by aforesaid compound which is not adsorbed to aforesaid semiconductor.

[Chemical Formula 1]

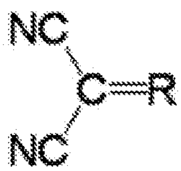

(1)

[In the formula, R denotes a fatty series group, an aromatic group or a heterocyclic group.]

[Chemical Formula 2]

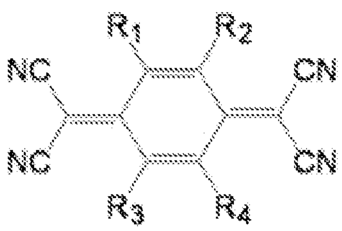

(2)

[In the formula, R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 3]

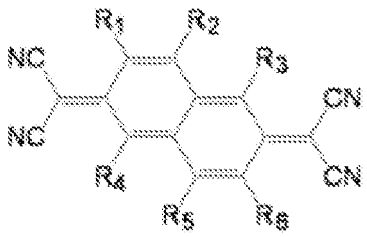

(3)

[In the formula, R1 to R6 may be the same or different one another and any one thereof denotes one of a hydrogen atom, a fatty series group, an aromatic group, a heterocyclic group and a halogen group in which any one of those may be substituted by a substituent group.]

[Chemical Formula 4]

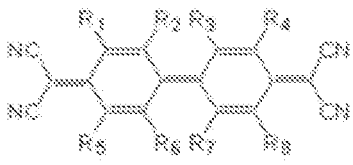

(4)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 5]

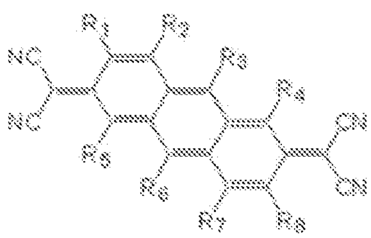

(5)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 6]

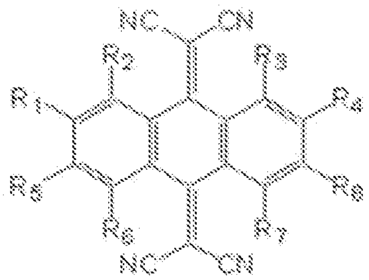

(6)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 7]

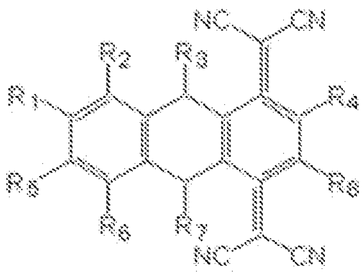

(7)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 8]

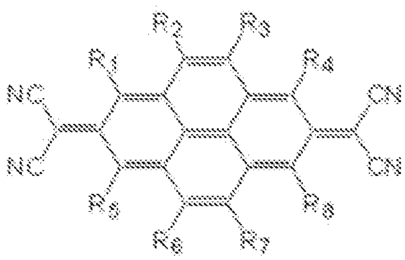

(8)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 9]

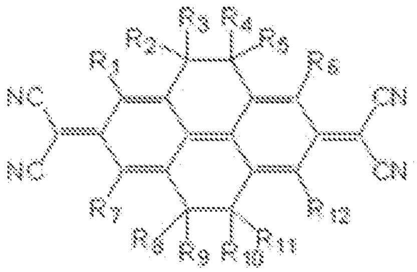

(9)

[R1 to R12 may be the same or different one another and any one thereof denotes one of a hydrogen atom, a fatty series group, an aromatic group, a heterocyclic group and a halogen group in which any one of those may be substituted by a substituent group.]

[Chemical Formula 10]

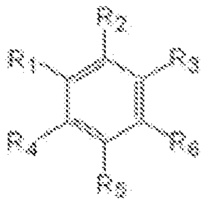

(10)

[R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 11]

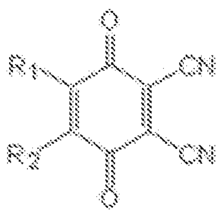

(11)

[R1, R2 may be the same or different mutually and any one thereof denotes one of a hydrogen atom, a fatty series group, an aromatic group, a heterocyclic group and a halogen group in which any one of those may be substituted by a substituent group.]

[Chemical Formula 12]

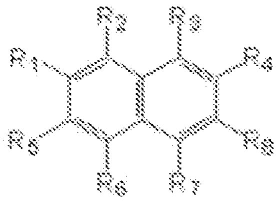

(12)

[R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13]

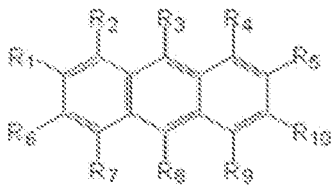

(13)

[R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13A]

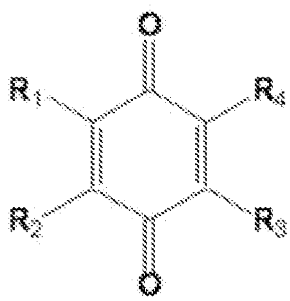

(13A)

[R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 13B]

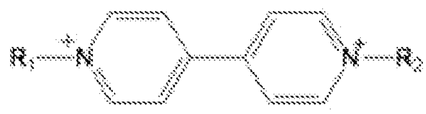

(13B)

[R1, R2 may be the same or different mutually and any one thereof denotes one of a hydrogen atom, a fatty series group, an aromatic group, a heterocyclic group and a halogen group in which any one of those may be substituted by a substituent group.]

$C_{60}$ (13C)

[$C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.]

According to this composition above, there is obtained a hybrid and/or complex material which can realize a high-efficient photoelectric conversion material or the like.

An eighth aspect of the present invention lies in a photoelectric conversion material including a hybrid and/or complex material according to any one claim from claim 1 to claim 7.

A ninth aspect of the present invention lies in a dye-sensitized solar cell including a hybrid and/or complex material according to any one claim from claim 1 to claim 7.

A tenth aspect of the present invention lies in a dye-sensitized solar cell device, characterized by including:

a first substrate;
a first conductive layer formed on aforesaid first substrate;
a Pt catalyst layer formed on aforesaid first conductive layer;
an electrolyte layer formed on aforesaid Pt catalyst layer;
a dye-adsorbed metal oxide layer formed on said electrolyte layer in which 7, 7, 8, 8-tetracyanoquinodimethane is adsorbed to anatase type titanium oxide;
a second conductive layer formed on aforesaid dye-adsorbed metal oxide layer; and

a second substrate formed on aforesaid second conductive layer.

According to this composition above, there is obtained a high-efficient dye-sensitized solar cell device in which light can be converted efficiently over wide wavelengths.

An eleventh aspect of the present invention lies in a photoelectric conversion device manufacturing method of manufacturing a photoelectric conversion device including:

a process for adsorbing a compound or its reductant expressed by any one of general formulas from (1) to (13C) mentioned below to a metal oxide and for forming a dye-adsorbed metal oxide layer; and
a process for arranging aforesaid dye-adsorbed metal oxide layer between two pieces of electrodes, wherein absorption of aforesaid dye-adsorbed metal oxide layer can be observed in a region of wavelengths different from absorption spectrum that is observed in a region from ultraviolet ray to near-infrared ray presented by aforesaid compound which is not adsorbed to aforesaid metal oxide.

[Chemical Formula 1]

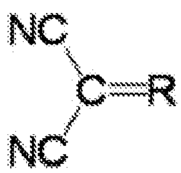

(1)

[In the formula, R denotes a fatty series group, an aromatic group or a heterocyclic group.]

[Chemical Formula 2]

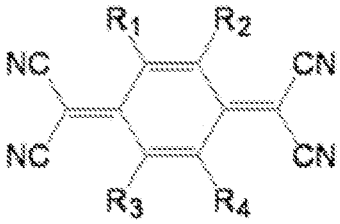

(2)

[In the formula, R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 3]

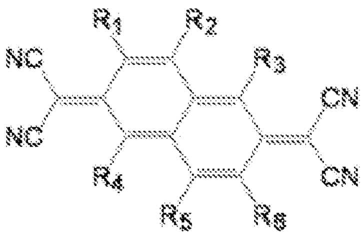

(3)

[In the formula, R1 to R6 may be the same or different one another and any one thereof denotes one of a hydrogen atom, a fatty series group, an aromatic group, a heterocyclic group and a halogen group in which any one of those may be substituted by a substituent group.]

[Chemical Formula 4]

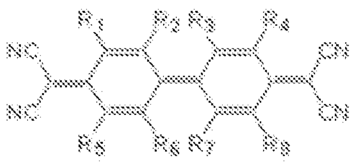

(4)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 5]

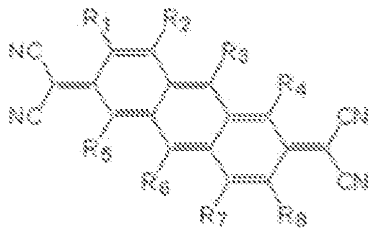

(5)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 6]

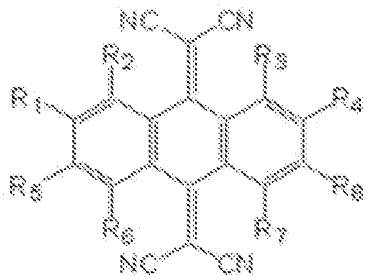

(6)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 7]

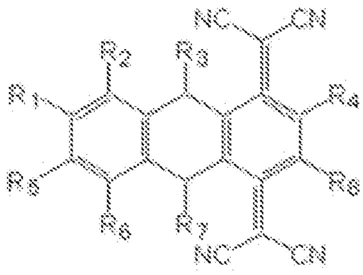

(7)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 8]

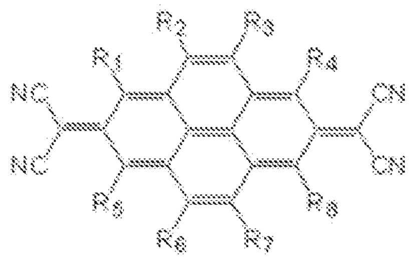

(8)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 9]

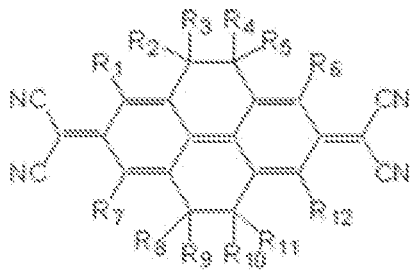

(9)

[R1 to R12 may be the same or different one another and any one thereof denotes one of a hydrogen atom, a fatty series group, an aromatic group, a heterocyclic group and a halogen group in which any one of those may be substituted by a substituent group.]

[Chemical Formula 10]

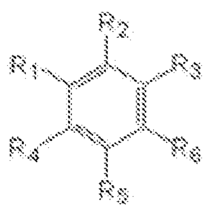

(10)

[R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 11]

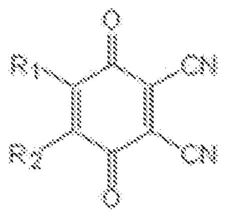

(11)

[R1, R2 may be the same or different mutually and any one thereof denotes one of a hydrogen atom, a fatty series group, an aromatic group, a heterocyclic group and a halogen group in which any one of those may be substituted by a substituent group.]

[Chemical Formula 12]

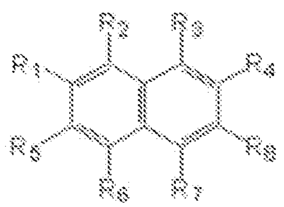

(12)

[R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13]

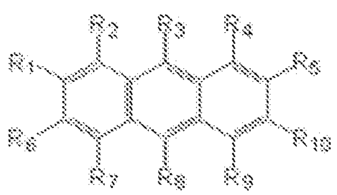

(13)

[R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13A]

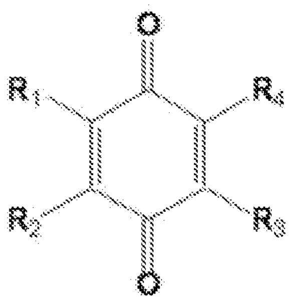

(13A)

[R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 13B]

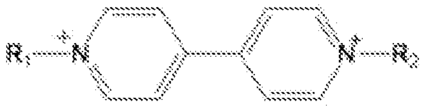

(13B)

[R1, R2 may be the same or different mutually and any one thereof denotes one of a hydrogen atom, a fatty series group, an aromatic group, a heterocyclic group and a halogen group in which any one of those may be substituted by a substituent group.]

$C_{60}$ (13C)

[$C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.]

According to this composition above, a high-efficient photoelectric conversion device is obtained.

A twelfth aspect of the present invention lies in a titanium oxide crystal structure analyzing method, characterized by obtaining information of crystal structure of aforesaid titanium oxide by adsorbing a compound or its reductant expressed by any one of general formulas from (1) to (13C) mentioned below is adsorbed to a titanium oxide.

[Chemical Formula 1]

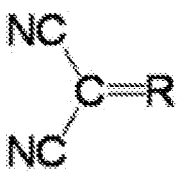

(1)

[In the formula, R denotes a fatty series group, an aromatic group or a heterocyclic group.]

[Chemical Formula 2]

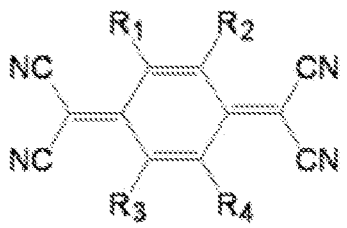

(2)

[In the formula, R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 3]

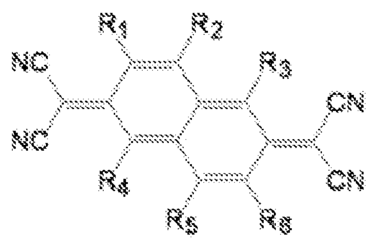

(3)

[In the formula, R1 to R6 may be the same or different one another and any one thereof denotes one of a hydrogen atom, a fatty series group, an aromatic group, a heterocyclic group and a halogen group in which any one of those may be substituted by a substituent group.]

[Chemical Formula 4]

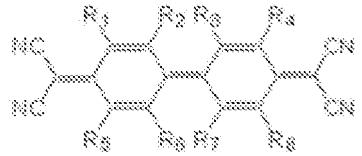

(4)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 5]

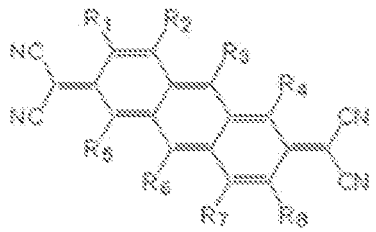

(5)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 6]

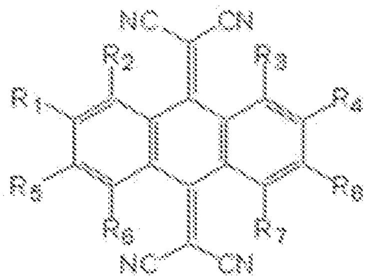

(6)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 7]

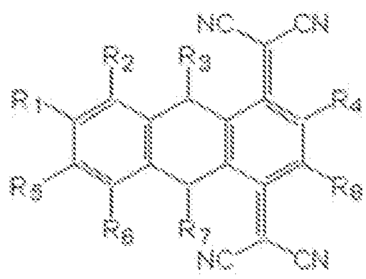

(7)

[In the formula, R1 to R8 may be the same or different one another and any one thereof denotes one of a hydrogen atom, a fatty series group, an aromatic group, a heterocyclic group and a halogen group in which any one of those

may be substituted by a substituent group.]

[Chemical Formula 8]

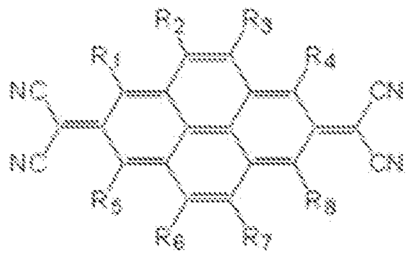

(8)

[In the formula, R1 to R8 may be the same or different one another and any one thereof denotes one of a hydrogen atom, a fatty series group, an aromatic group, a heterocyclic group and a halogen group in which any one of those may be substituted by a substituent group.]

[Chemical Formula 9]

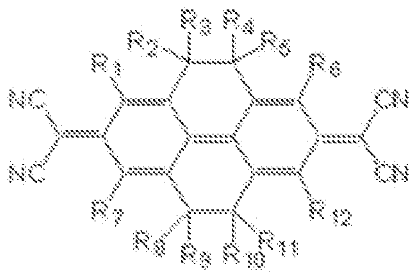

(9)

[R1 to R12 may be the same or different one another and any one thereof denotes one of a hydrogen atom, a fatty series group, an aromatic group, a heterocyclic group and a halogen group in which any one of those may be substituted by a substituent group.]

[Chemical Formula 10]

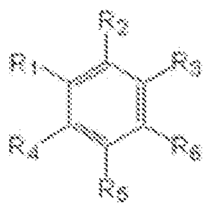

(10)

[R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 11]

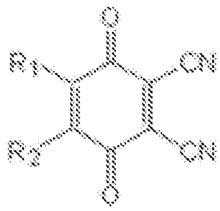

(11)

[R1, R2 may be the same or different mutually and any one thereof denotes one of a hydrogen atom, a fatty series group, an aromatic group, a heterocyclic group and a halogen group in which any one of those may be substituted by a substituent group.]

[Chemical Formula 12]

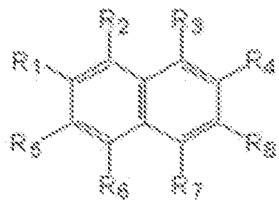

(12)

[R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13]

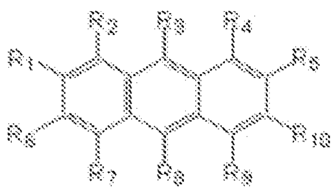

(13)

[R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups.]

[Chemical Formula 13A]

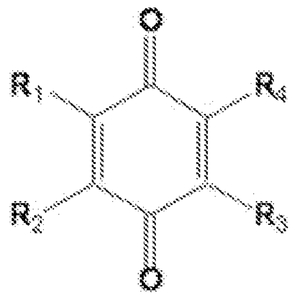

(13A)

[R1 to R4 may be the same or different one another and any one thereof denotes one of a hydrogen atom, a fatty series group, an aromatic group, a heterocyclic group and a halogen group in which any one of those may be substituted by a substituent group.]

[Chemical Formula 13B]

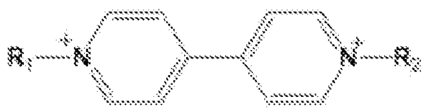

(13B)

[R1, R2 may be the same or different mutually and any one thereof denotes one of a hydrogen atom, a fatty series group, an aromatic group, a heterocyclic group and a halogen group in which any one of those may be substituted by a substituent group.]

$C_{60}$ (13C)

[$C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.]

According to this composition, it is possible to obtain information relating to crystal structures such as an anatase type and a rutile type of a titanium oxide by a simple method.

A thirteenth aspect of the present invention lies, in a hybrid and/or complex material in which an electron acceptable organic molecule is adsorbed to a metal oxide, in a hybrid and/or complex material, **characterized in that** aforesaid electron acceptable organic molecule has the lowest unoccupied energy level which has a larger energy difference from the vacuum energy level compared with that of the lowest energy level of the electron conductor of aforesaid metal oxide, and

absorption can be observed in a region of wavelengths different from absorption spectrum that is observed in a region from ultraviolet ray to near-infrared ray presented by aforesaid electron acceptable organic molecule which is not adsorbed to aforesaid metal oxide.

According to this composition above, it is possible to obtain a useful photoelectric conversion material or the like.

It should be noted with respect to the fatty series group that it is allowed for the fatty series region thereof to be saturated or to be unsaturated in a state of a straight chain or a branched chain and, for example, the fatty series group may denote one of an alkyl group, an alkenyl group and an alkynyl group in which any one of those may be unsubstituent or may include a substituent group. It is allowed for the aromatic group or the heterocyclic group to be of a single ring or of a condensed ring, and it may be unsubstituent or may include a substituent group. Halogen is, for example, fluorine, chlorine, bromine, iodine or astatine, and is an element of a typical element 17 group.

In case of forming a reductant sodium, for example, there is a case in which the compound mentioned above is reduced by accepting an electron.

In absorption, there are included physical absorption adsorbed by means of electrostatic force, van der Waals force or the like and chemical absorption by means of coordinate bond, covalent bond or the like.

As mentioned above, it is preferable for absorption of the hybrid and/or complex material to be observed in a region of wavelengths different from absorption spectrum that is observed in a region from ultraviolet ray to near-infrared ray presented by the compound mentioned above which is not adsorbed to a metal oxide or the like. New absorption of this hybrid and/or complex material may not be in the region from ultraviolet ray to near-infrared ray, but it is more preferable if it is in the region from ultraviolet ray to near-infrared ray. Also, it is more preferable for the new absorption of this hybrid and/or complex material to be observed in the longer wavelength side than the absorption spectrum side that is observed in the region from ultraviolet ray to near-infrared ray presented by the compound mentioned above which is not adsorbed to a metal oxide or the like. Here, the region from ultraviolet ray to near-infrared ray is, for example, a region of wavelengths from 200nm or more to 3000nm or less.

It should be noted in the absorption spectrum measurement in the region from ultraviolet ray to near-infrared ray that it is also preferable for the skirt of the long wavelength side of the absorption spectrum presented by the hybrid and/or complex material to be observed in the longer wavelength side than the skirt of the long wavelength side of absorption spectrum presented by the compound mentioned above which is not adsorbed to a metal oxide or the like. Also, in the absorption spectrum measurement in the region from ultraviolet ray to near-infrared ray, it is preferable for the absorption spectrum presented by the hybrid and/or complex material to appear in the longer wavelength side than the absorption spectrum presented by the compound mentioned above which is not adsorbed to a metal oxide or the like.

## Effect of the Invention

According to the present invention, there are obtained a hybrid and/or complex material and the like which can realize a high-efficient photoelectric conversion material and the like.

Still other objects, characteristics or advantages of the present invention will be clarified according to detailed explanations to be described, which are based on exemplified embodiments and attached drawings of the present invention.

## BRIEF DESCRIPTION OF DRAWINGS

FIG. 1 is across-section structure of a dye-sensitized solar cell;

FIG. 2 shows absorption spectra of TCNQ and of a titanium oxide for which dipping process to a TCNQ solution was performed;

FIG. 3 is an IPCE spectrum of a photoelectric conversion device using TCNQ;

FIG. 4 shows absorption spectra of TCNE and of a titanium oxide for which dipping process to a TCNE solution was performed;

FIG. 5 is an IPCE spectrum of a photoelectric conversion device using TCNE;

FIG. 6 shows absorption spectra of TCNQ-$F_4$ and of a titanium oxide for which dipping process to a TCNQ-$F_4$ solution was performed;

FIG. 7 is an IPCE spectrum of a photoelectric conversion device using TCNQ-$F_4$;

FIG. 8 shows absorption spectra of TCNAQ and of a titanium oxide for which dipping process to a TCNAQ solution was performed;

FIG. 9 is an IPCE spectrum of a photoelectric conversion device using TCNAQ;

FIG. 10 is an absorption spectrum of a titanium oxide after being dipped in an acetonitrile solution of methyl viologen;

FIG. 11 is a diagram showing a result in which IPCE of a solar cell was measured in a range from 300nm to 1100nm;

FIG. 12 is a diagram showing a result in which a current-voltage characteristic of a solar cell was measured by using a solar simulator and by illuminating a quasi solar light source (AM1.5, OOMW/$cm^2$);

FIG. 13 is an absorption spectrum of a titanium oxide after being dipped in an acetonitrile solution of chloranil;

FIG. 14 is a diagram showing a result in which IPCE of a solar cell was measured in a range from 300nm to 1100nm;

FIG. 15 is a diagram showing a result in which a current-voltage characteristic of a solar cell was measured by using a solar simulator and by illuminating a quasi solar light source (AM1.5, 100mW/$cm^2$);

FIG. 16 shows LiI concentration dependency of an IPCE spectrum of a photoelectric conversion device using TCNQ;

FIG. 17 is a diagram showing color changes of a titanium oxide before and after adsorbing TCNQ to anatase and rutile types of $TiO_2$; and

FIG. 18 is a diagram showing color changes when dipping a titanium oxide, in which anatase and rutile are mixed, into a TCNQ solution.

DESCRIPTION OF REFERENCE NUMERALS

10 Dye-Sensitized Solar Cell Device
11 Glass Substrate
12 Conductive Layer
13 Electrolyte Layer
14 dye-adsorbed metal Oxide Layer
15 Transparent Conductive Layer
16 Glass Substrate

BEST MODE FOR CARRYING OUT THE INVENTION

Hereinafter, it will be explained with respect to exemplified embodiments of the present invention in detail with reference to drawings.

[Brief Summary]

The present inventers, as a result of earnestly doing research repeatedly, found out that a boundary-surface complex constituted by an organic molecule including a cyano group and a metal oxide or the like presents a wide-range light absorption from a visible region beyond a near-infrared region which are different from respective absorption regions. For an example of the organic molecule including the cyano group, it is possible to illustrate a lot of compounds such as tetracyanoquinodimethane (TCNQ).

According to this exemplified embodiment, it is possible for the organic molecule including a cyano group to use a highly general-purposed commercialized organic molecule in which steep cost reduction of a dye material is possible compared with a case of using tetracyanoquinodimethane or the like as an Ru metal complex, and further reduction of the manufacturing cost becomes possible.

Hereinafter, it will be explained in detail with respect to this exemplified embodiment.

[Chemical Compound, etc.]

In a dye-sensitization type solar cell of a constitution in which, on conductive substrates having light permeability and being faced with a predetermined distance apart, there are faced a photoelectric conversion electrode including a semiconductor layer and a photo-sensitizing dye and an electrode including a catalyst layer of Pt or the like on a conductive substrate , an electrolyte layer is placed between those substrates and the peripheral portion between those substrates is sealed, the photo-sensitizing dye presents a wide-range absorption from a visible region beyond a near-infrared region.

FIG. 1 is a diagram showing an example of a cross-section structure of a dye-sensitized solar cell device. In a dye-sensitized solar cell device 10, there are layered a glass substrate 11, a conductive layer 12 with a Pt thin film, an electrolyte layer 13, a dye-adsorbed metal oxide layer 14, a transparent conductive layer 15 and a glass substrate 16 in the order from the bottom thereof. In this dye-sensitized solar cell device, the glass substrate 11 and the glass substrate 16 are faced to each other with a predetermined distance apart. The glass substrate 16 on the one side is provided with a semiconductor and an organic molecule on the conductive substrate 15 having light permeability and includes the dye-adsorbed metal oxide layer 14 which performs photoelectric conversion, and the facing glass substrate 11 includes a catalyst layer on the conductive substrate 12 formed thereon, and the electrolyte layer 13 is placed between those substrates and a seal member is placed on the peripheral portion between those substrates whereby a cell is formed.

Also, a general formula of the organic molecule according to this exemplified embodiment is expressed, for example, by $R(CN)_n$ (n is integer of 2 or more). It is also possible to use a plurality of organic molecules by being mixed. Preferably, there is cited an organic molecule including a dicyano group. Specifically, there can be cited molecules shown hereinafter.

[Chemical Formulas 16]

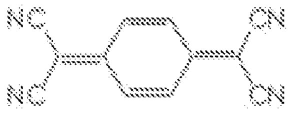

TCNQ

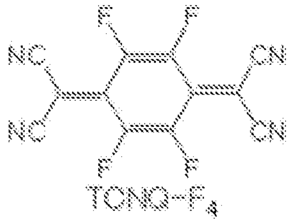

TCNQ-$F_4$

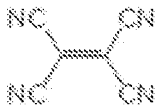

TCNE

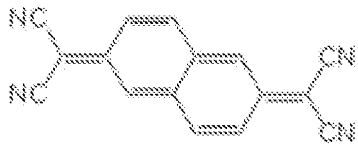

TCNAQ

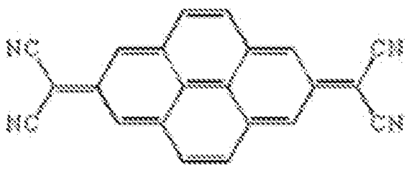

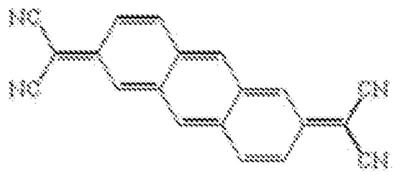

Also, including compounds being overlapped with the compounds mentioned above, for example, there was confirmed for the compounds mentioned below about coloring in a state of being adsorbed to a titanium oxide, and it is conceivable that similar effects as those of the compounds mentioned above will be demonstrated.

[Chemical Formulas 17]

(i) 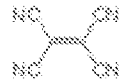
TCNE

(v) 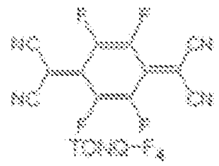
TCNQ-$F_4$

(ix) 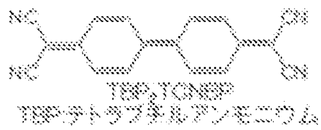
TBP$_2$TCNEB
TBP:テトラブチルアンモニウム

(ii) 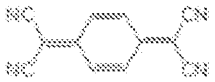
TCNQ

(vi) 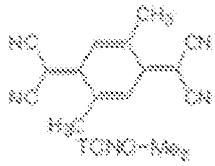
TCNQ-$Me_2$

(x) 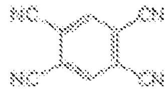
TCB

(iii) 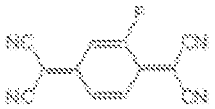
TCNQ-F

(vii) 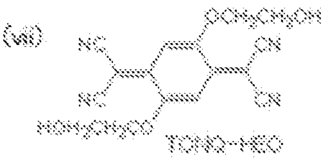
TCNQ-HEO

(xi) 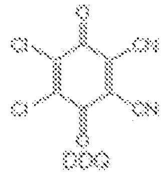
DDQ

(iv) 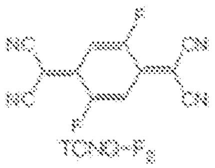
TCNQ-$F_2$

(viii) 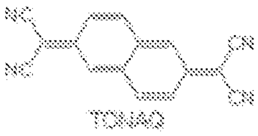
TCNAQ

(xii) 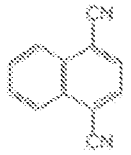
DCNN

Further, a compound and its reductant expressed by a general formula mentioned below also includes an equivalent framework or substituent group, so that it is conceivable that similar effects as those of the compound mentioned above will be demonstrated.

[Chemical Formula 18]

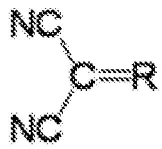

R denotes a fatty series group, an aromatic group or a heterocyclic group. It should be noted that this compound will follow the general formulas with respect to the compounds (i) to (ix) mentioned above.

[Chemical Formula 19]

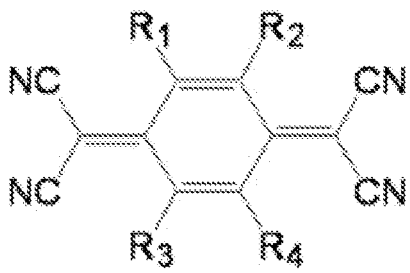

R1 to R4 may be the same or different one another and any one thereof denotes one of a hydrogen atom, a fatty series group, an aromatic group, a heterocyclic group and a halogen group in which any one of those may be substituted by a substituent group. It should be noted that this compound will follow the general formulas with respect to the compounds (ii) to (vii) mentioned above.

Here, it is preferable for the carbon number of the fatty series group to be from 1 or more to 30 or less, and it is more preferable to be from 1 or more to 20 or less. Also, it is preferable for the carbon number of the aromatic group or the heterocyclic group to be 6 or more to 30 or less, and it is more preferable to be 1 or more to 20 or less. It is similar also in the following general formula.

[Chemical Formula 20]

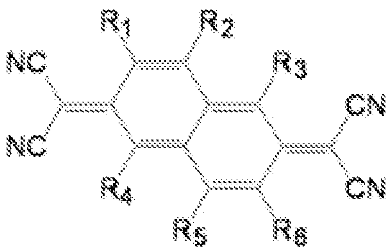

R1 to R6 may be the same or different one another and any one thereof denotes one of a hydrogen atom, a fatty series group, an aromatic group, a heterocyclic group and a halogen group in which any one of those may be substituted by a substituent group. It should be noted that this compound will follow the general formula with respect to the compound (viii) mentioned above.

[Chemical Formula 21]

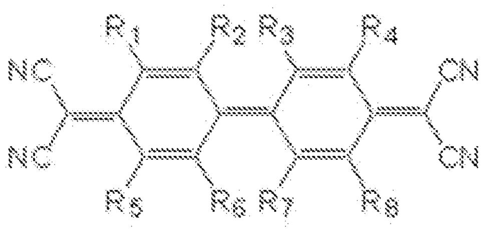

R1 to R8 may be the same or different one another and any one thereof denotes one of a hydrogen atom, a fatty series group, an aromatic group, a heterocyclic group and a halogen group in which any one of those may be substituted by a substituent group. It should be noted that this compound will follow the general formula with respect to the compound (ix) mentioned above.

[Chemical Formula 22]

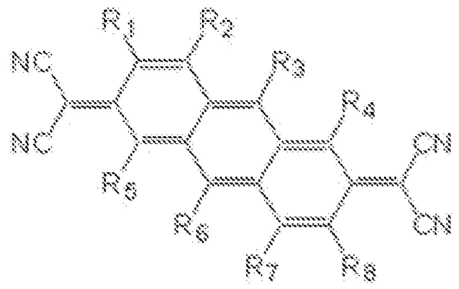

R1 to R8 may be the same or different one another and any one thereof denotes one of a hydrogen atom, a fatty series group, an aromatic group, a heterocyclic group and a halogen group in which any one of those may be substituted by a substituent group.

[Chemical Formula 23]

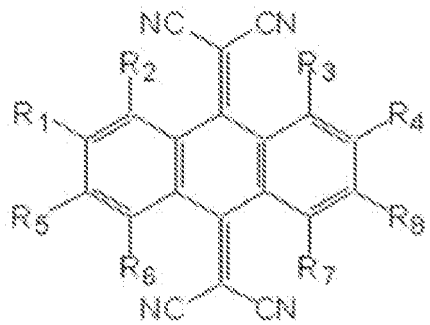

R1 to R8 may be the same or different one another and any one thereof denotes one of a hydrogen atom, a fatty series group, an aromatic group, a heterocyclic group and a halogen group in which any one of those may be substituted by a substituent group.

[Chemical Formula 24]

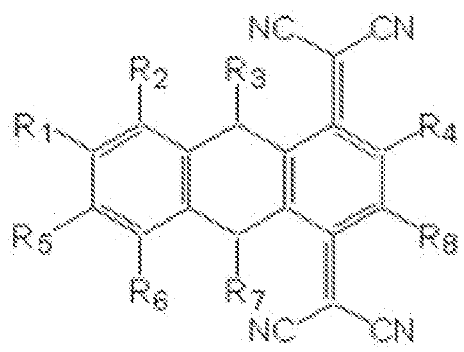

R1 to R8 may be the same or different one another and any one thereof denotes one of a hydrogen atom, a fatty series group, an aromatic group, a heterocyclic group and a halogen group in which any one of those may be substituted by a substituent group.

[Chemical Formula 25]

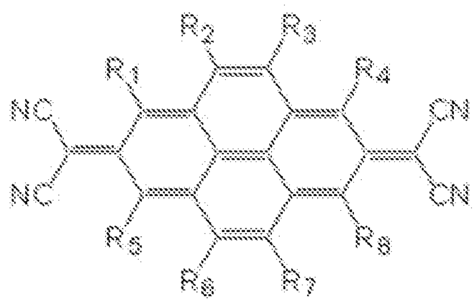

R1 to R8 may be the same or different one another and any one thereof denotes one of a hydrogen atom, a fatty series group, an aromatic group, a heterocyclic group and a halogen group in which any one of those may be substituted by a substituent group.

[Chemical Formula 26]

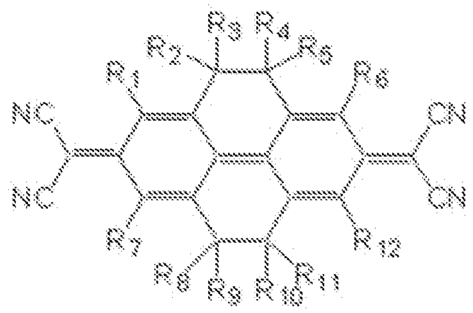

R1 to R12 may be the same or different one another and any one thereof denotes one of a hydrogen atom, a fatty series group, an aromatic group, a heterocyclic group and a halogen group in which any one of those may be substituted by a substituent group.

[Chemical Formula 27]

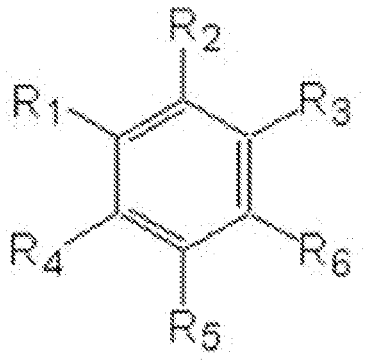

R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups. It should be noted that this compound will follow the general formula with respect to the compound (x) mentioned above.

[Chemical Formula 28]

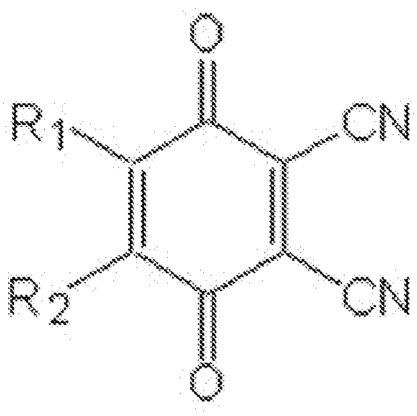

R1 and R2 may be the same or different one another and any one thereof denotes one of a hydrogen atom, a fatty series group, an aromatic group, a heterocyclic group and a halogen group in which any one of those may be substituted by a substituent group. It should be noted that this compound will follow the general formula with respect to the compound (xi) mentioned above.

[Chemical Formula 29]

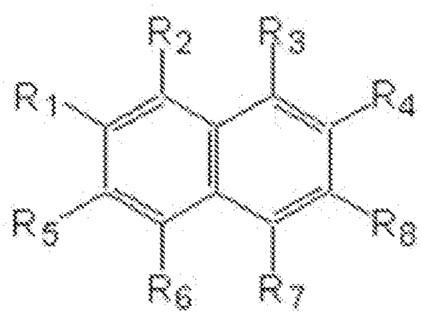

R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups. It should be noted that this compound will follow the general formula with respect to the compound (xii) mentioned above.

[Chemical Formula 30]

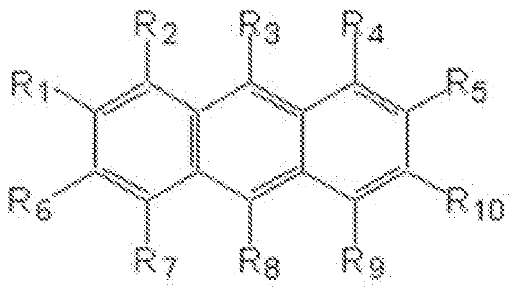

R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups.

[Chemical Formula 31A]

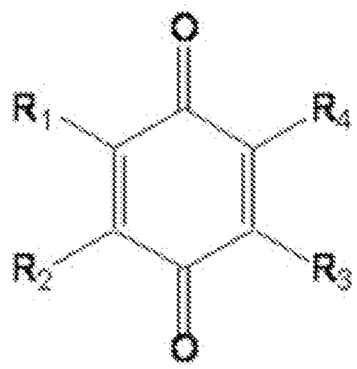

R1 to R4 may be the same or different one another and any one thereof denotes one of a hydrogen atom, a fatty series group, an aromatic group, a heterocyclic group and a halogen group in which any one of those may be substituted by a substituent group.

[Chemical Formula 31B]

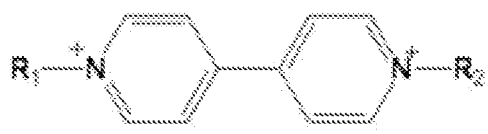

R1 and R2 may be the same or different one another and any one thereof denotes one of a hydrogen atom, a fatty series group, an aromatic group, a heterocyclic group and a halogen group in which any one of those may be substituted by a substituent group.

$C_{60}$ (13C)

$C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.

For an example of the fullerene molecule, there can be cited $C_{60}$ mentioned below, $C_{60}$ derivative in which at least a portion thereof is substituted or the like.

[Chemical Formula 31C]

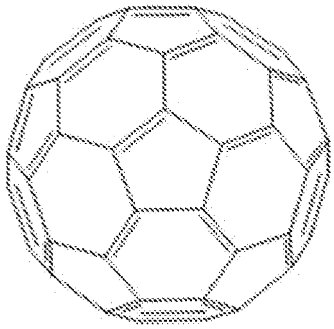

[Chemical Formula 31D]

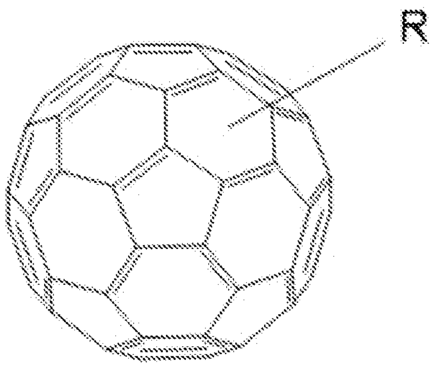

[Other Exemplified Example]

For a method of adsorbing an organic molecule to a metal oxide or for a method of arranging an organic molecule on a metal oxide, there exist a method in which the metal oxide is dipped into a solution dissolved with the organic molecule and a method in which it is possible to apply coating on the organic molecule solution by using a general wet-type film-forming process of a spray method, a spin-coat method, a doctor blade method, a printing procedure of such as a gravure method, or the like. Also, it is possible for the organic molecule to use a vapor deposition method by resistance heating and electron beam heating and to use a dry-type method of such as molecule beam epitaxy. Further, in case of using a dipping method, it happens, for the concentration of the organic molecule, that the most suitable value thereof will be selected accordingly depending on the used organic molecule and solvent and, for example, it is from 0.1mM or more to 10mM or less and preferably, it is from 0.5mM or more to 5mM or less. Also, the dipping period thereof is from 10 minutes or more to 200 hours or less and preferably, it is from 10 hours or more to 100 hours or less. Also, for example, the temperature on an occasion of the dipping in a dye solution is from 0°C or more to 100°C or less and preferably, it is from 10°C or more to 50°C or less.

For the solvent to be used, there is no limitation particularly if the solvent dissolves a dye and does not dissolve a semiconductor layer at the same time and it is possible to use an alcohol of methanol, ethanol, 1-propanol, 2-propanol, 1-butanol, 2-butanol, t-butanol or the like; a nitrile-based solvent of acetonitrile, propiononitrile, methoxypropionitrile, glutaronitrile or the like; benzene; toluene; o-xylene; m-xylene; p-xylene; pentane; heptane; hexane; cyclohexane; heptane; acetone; methyl ethyl ketone; diethyl ketone; 2-butanone; diethyl ether; tetrahydrofuran; ethylene carbonate; propylene carbonate; nitromethane; dimethylformamide; dimethyl sulfoxide; hexamethyl phosphoamide; dimethoxyethane; γ-butyrolactone; γ-valerolactone; sulfolane; dimethoxyethane; adiponitrile; methoxyacetonitrile; dimethylacetamide; methylpyrrolidinone; dimethyl sulfoxide; dioxolan; sulfolane; trimethyl phosphate; triethyl phosphate; tripropyl phosphate; ethyl dimethyl phosphate; tributyl phosphate; tripentyl phosphate; trihexyl phosphate; trihexyl phosphate; trioctyl phosphate; trinonyl phosphate; tridecyl phosphate; tris phosphate (trifluoromethyl); tris phosphate (pentafluoroethyl); triphenyl phosphate polyethylene glycol; polyethylene glycol; and the like.

In the photoelectric conversion device of this exemplified embodiment, there is no limitation particularly for the semiconductor layer to be used, but it is, for example, $SnO_2$, $TiO_2$, $WO_3$ or ZnO and it may be a combination of a plurality thereof. In particular, preferably, it is $TiO_2$, ZnO or $SnO_2$ and most preferably, it is $TiO_2$ or ZnO.

A semiconductor used in this exemplified embodiment may be of a single crystal or of a polycrystalline. For the crystal system, there is mainly used an anatase type, a rutile type, a brookite-type or the like and preferably, an anatase type is used. It is possible for the formation of the semiconductor layer to use a publicly well-known method.

It is possible for a forming method of the semiconductor layer to be obtained by coating a nanoparticles dispersion liquid, a sol solution or the like of aforesaid semiconductor on a substrate by means of a publicly well-known method. For a coating method in this case, there is no limitation particularly and there can be cited various kinds of printing methods starting from a screen printing method other than the methods of a method in which coating is obtaining in a thin film state by means of a cast method, a spin-coat method, a deep-coat method and a bar-coat method.

The thickness of the semiconductor layer is optional, but it is from 0.5μm or more to 50μm or less and preferably, it is from 1μm or more to 30μm or less.

For a substrate having conductivity, it is also allowed to use a substrate in which a conductive layer is formed on a substrate without having conductivity and a substrate in which the substrate itself has conductivity. Also, it is possible to select the quality of material, the thickness, the size, the shape and the like accordingly depending on the purpose. For the substrate, there can be used, for example, a colorless or colored glass and the like other than a metal of gold, silver, copper or the like. Also, it is also allowed to use resins having colorless or colored transparency. For those resins, specifically, there can be cited polyester of polyethylene terephthalate or the like, polyamide, polysulfone, polyethersulphone, polyetheretherketone, polyphenylene sulfide, polycarbonate, polyimide, polymethyl methacrylate, polystyrene, triacetylcellulose, polymethylpentene and the like. It should be noted that the substrate in this exemplified embodiment means a substrate having, for example, a flat and smooth surface in a room temperature, and the surface thereof may be a plane surface or a curved surface and also, may be a surface which deforms caused by a stress. Also, in order to give conductivity to the substrate, it is also allowed for the surface thereof to be arranged, for example, with a metal thin film of gold, silver, chrominum, copper, tungsten or the like or with a conductive film composed of a metal oxide. For the metal oxide, it is possible, as a suitable metal oxide, to use, for example, Indium Tin Oxide (ITO ($In_2O_3$: Sn)), Fluorine doped Tin Oxide (FTO ($SnO_2$: F)), Aluminum doped Zinc Oxide (AZO (ZnO: Al)) or the like, in which a metal oxide of indium, tin, zinc or the like is doped with other metal element by a very small amount.

For a conductive film, it has thickness, for example, from 10nm to 2μm, and preferably, from 100nm to 1μm and also, the sheet resistance thereof is, for example, from 0.5Ω/sq to 100Ω/sq and preferably, from 2Ω/sq to 50Ω/sq. It is possible for those conductive films to be formed on the substrate by a publicly well-known method such as a vacuum evaporation method, an ion plating method, a CVD method, an electron beam vacuum evaporation method, sputtering method and the like.

Next, it will be explained with respect to a transparent conductive substrate.

A transparent conductive substrate is manufactured, for example, by being layered with a transparent electrode layer on a transparent substrate. For the transparent substrate, there is no limitation particularly and it is possible to select the quality of material, the thickness, the size, the shape and the like accordingly depending on the purpose, and for example, other than that a colorless or colored glass, a wired glass, a glass block or the like is used, it is also allowed to use a resin having colorless or colored transparency. Specifically, there are cited polyester of polyethylene terephthalate or the like, polyamide, polysulfone, polyethersulfone, polyetheretherketone, polyphenylene sulfide, polycarbonate, polyimide, polymethyl methacrylate, polystyrene, triacetylcellulose, polymethylpentene and the like. It should be noted that transparency in this exemplified embodiment means transparency having transmissivity of, for example, from 30% to 100% and also, the substrate in this exemplified embodiment means a substrate having, for example, a flat and smooth surface in a room temperature, and the surface thereof may be a plane surface or a curved surface and also, may be a surface which deforms caused by a stress.

For an electrolyte of a liquid system, there is no limitation particularly and, for example, it is constituted by making a solvent, a substance presenting a reversible electrochemical like oxidation-reduction characteristic (which is soluble into a solvent) and further, if required, a supporting electrolyte as basic components.

It is possible for the solvent to use any solvent if it is a solvent generally used for an electrochemical cell and a battery. Specifically, it is possible to use acetic anhydride, methanol, ethanol, tetrahydrofuran, propylene carbonate, nitromethane, acetonitrile, dimethylformamide, dimethyl sulfoxide, hexamethyl phosphoamide, ethylene carbonate,

dimethoxyethane, γ-butyrolactone, γ-valerolactone, sulfolane, dimethoxyethane, propionitrile, glutaronitrile, adiponitrile, methoxyacetonitrile, dimethylacetamide, methylpyrrolidinone, dimethyl sulfoxide, dioxolan, sulfolane, trimethyl phosphate, triethyl phosphate, tripropyl phosphate, ethyl dimethyl phosphate, tributyl phosphate, tripentyl phosphate, trihexyl phosphate, trihexyl phosphate, trioctyl phosphate, trinonyl phosphate, tridecyl phosphate, tris phosphate (trifluoromethyl), tris phosphate (pentafluoroethyl), triphenyl phosphate polyethylene glycol and polyethylene glycol or the like. Particularly, it is preferable to use propylene carbonate, ethylene carbonate, dimethyl sulfoxide, dimethoxyethane, acetonitrile, γ-butyrolactone, sulfolane, dioxolan, dimethylformamide, dimethoxyethane, tetrahydrofuran, adiponitrile, methoxyacetonitrile, methoxypropionitrile, dimethylacetamide, methylpyrrolidinone, dimethyl sulfoxide, dioxolan, sulfolane, trimethyl phosphate or triethyl phosphate.

In addition, it is also possible for the solvent to use a room-temperature molten salt. Here, the room-temperature molten salt means, for example, a salt being composed only of an ion pair in which a solvent component is not included and being composed of an ion pair which is melted (that is, in a liquid state) at the room-temperature, and indicates a salt being composed of an ion pair whose melting point is 20°C or less and which is in a liquid state at the temperature exceeding 20°C.

Also, for the substance presenting reversible electrochemical like oxidation-reduction characteristics, there can be cited, for example, a substance referred to as a so-called redox material, but the kind thereof has no limitation particularly. For such a substance, there can be cited, for example, ferrocene; p-benzoquinone; 7, 7, 8, 8-tetracyanoquinodimethane; N, N, N', N'-tetramethyl-p-phenylenediamine; tetrathiafulvalene; thianthracene; p-toluic amine and the like. In addition, there can be cited LiI; NaI; KI; CsI; $CaI_2$; an iodine salt of quaternary imidazolium; an iodine salt of tetraalkylammonium; a metal bromide of $Br_2$ and LiBr, NaBr, KBr, CsBr, $CaBr_2$ or the like; and the like, and there can be also cited $Br_2$ and tetraalkylammonium bromide; bipyridinium bromide; bromine salt; a complex salt such as of ferrocyanic acid-ferricyanic acid salt; poly sodium sulfide; alkylthiol-alkyl disulfide; hydroquinone-quinone; viologen dye; and the like.

For the redox material, it is allowed to use only one of an oxidant and a reductant and it is also possible for the oxidant and the reductant to be mixed by a suitable molar ratio and to be added. Also, it is also allowed to add these oxidation-reduction pair, or the like so as to present electrochemical responsiveness. It is also possible for a material presenting such a characteristic to use a halogen class of such as iodine, bromine, chlorine and the like other than a metallocenium salt of ferrocenium including pair anions selected from halogen ion, $SCN^-$, $ClO_4^-$, $BF_4^-$, $CF_3SO_3^-$, $(CF_3SO_2)_2N^-$, $(C_2F_5SO_2)_2N^-$, $PF_6^-$, $AsF_6^-$, $CH_3COO^-$, $CH_3(C_6H_4)SO_3^-$ and $(C_2F_5SO_2)_3C^-$, and the like.

Also, it is possible for the substance presenting the reversible electrochemical like oxidation-reduction characteristics to use also a redox room-temperature molten salt. Here, the redox room-temperature molten salt means, for example, a salt being composed only of an ion pair in which a solvent component is not included and being composed of an ion pair which is melted (that is, in a liquid state) at the room-temperature and, for example, it is a salt being composed of an ion pair whose melting point is 20°C or less and which is in a liquid state at the temperature exceeding 20°C and also, it is a salt which can perform a reversible electrochemical like oxidation-reduction reaction.

With respect to the redox room-temperature molten salt, it is possible to use one kind thereof singularly and in addition, it is also possible to use the salt even by mixing two kinds or more.

The use amount of the substance presenting the reversible electrochemical like oxidation-reduction characteristics is not limited particularly as long as being dissolved into a solvent, and with respect to the solvent, it is, for example, from 1 to 50 mass percent and preferably, from 3 to 30 mass percent.

Also, for a supporting electrolyte which is added if required, there can be used a salt, an acid, an alkali and a room-temperature molten salt which are used generally in the field of electrochemistry or in the field of battery.

For a salt class, there is no limitation in particular and there can be used, for example, an alkali metal salt; an inorganic ion salt of an alkaline earth metal salt or the like; a quaternary ammonium salt; a ring quaternary ammonium salt; a quaternary phosphonium salt; or the like, and particularly, a Li salt of lithium iodide or the like is preferable.

It should be noted for the concentration in case of adding a lithium salt to the electrolyte that there exists a range of suitable amount in response to the kinds of the metal oxide and the organic molecule. For example, in case of producing a photoelectric conversion device by using a photoelectric conversion layer in which TCNQ is adsorbed to a titanium oxide, there can be identified improvement of the photoelectric conversion efficiency when adding 1.0mol/L to 2.0mol/L of the lithium salt into the electrolytic solution.

Also, for the electrolyte, it is allowed to use the liquid system such as aforesaid, but it is also allowed to use a high polymer solid body electrolyte (ion conductive film). For the high polymer solid body electrolyte, there can be cited, as a particularly preferable electrolyte, an electrolyte which contains, for the high polymer matrix, a substance presenting at least a reversible electrochemical like oxidation-reduction characteristic and further which contains a plasticizer if desired. Also, in addition to those, it is also allowed, if desired, to further contain other optional components of the supporting electrolyte and the room-temperature molten salt mentioned above and the like.

For a material which can be used as the high polymer matrix, there is no limitation in particular if it is of a high polymer matrix single body, or if a solid state or a gel state is formed due to addition of a plasticizer, addition of a

supporting electrolyte or addition of a plasticizer and a supporting electrolyte, and it is possible to use a so-called high polymer compound used in general.

For a high polymer compound presenting a characteristic as aforesaid high polymer matrix, there can be cited a high polymer compound obtained by polymerizing or co-polymerizing a monomer of hexafluoropropylene, tetrafluoroethylene, trifluoroethylene, ethylene, propylene, acrylonitrile, vinylidene chloride, acrylic acid, methacrylic acid, methyl acrylate, ethyl acrylate, methyl methacrylate, styrene, vinylidene difluoride or the like. Also, it is allowed for these high polymer compounds to be used singularly or it is also allowed to be used by mixture. Even out of those, in particular, a polyvinylidene-fluoride-based high polymer compound is preferable.

In order to supplement (sun) light absorption in the region which the organic compound mentioned above can not cover for the sensitizing dye, it is possible to be used by combining with other sensitizing dye. Here, as other sensitizing dyes, there can be cited azo-based dye, quinacridone-based dye, diketopyrrolopyrrole-based dye, squarylium-based dye, cyanine-based dye, merocyanine-based dye, triphenylmethane-based dye, xanthene-based dye, porphyrin-based dye, chlorophyll-based dye, ruthenium complex-based dye, indigo-based dye, perylene-based dye, dioxazine-based dye, anthraquinone-based dye, phthalocyanine-based dye, naphthalocyanine-based dye and the like, and the derivatives thereof and the like. It is also preferable for those sensitizing dyes to include such a functional group which can be adsorbed to the surface of the inorganic semiconductor porous medium in the structures thereof. As a reason thereof, it is cited that excited electrons of a photo-excited dye can be transmitted to the conduction band of the inorganic semiconductor porous medium rapidly. With respect to the functional group which is referred to here, there can be cited a carboxyl group, a hydroxy group, a hydroxamic acid group, a sulfonic acid group, a phosphonic acid group, and a phosphinic acid group or the like, but it is not limited only by those if it is a substituent group having the role of transmitting the excited electrons of the dye to the conduction band of the inorganic semiconductor porous medium rapidly by adsorbing the sensitizing dye to the surface of the inorganic semiconductor porous medium.

Also, it is also allowed for the organic compound mentioned above to form a photoelectric conversion material in which an inorganic semiconductor porous medium is sensitized by being adsorbed to the surface of the inorganic semiconductor porous medium through an absorption group as the sensitizing dye for photoelectric conversion. An inorganic semiconductor, generally, has a photoelectric conversion function with respect to the light in a partial region and due to a fact that the surface thereof adsorbs the sensitizing dye, it become possible also for the photoelectric conversion to be performed up to a visible light region and/or a near-infrared light region. For a material of the inorganic semiconductor porous medium, there is used an inorganic oxide mainly and a metal oxide particularly, but it is not limited only by this if there is used an inorganic semiconductor porous medium having a photoelectric conversion function by adsorbing a sensitizing dye. For an inorganic semiconductor, there can be cited silicon, germanium, III-group to V-group based semiconductors, metal chalcogenide and the like. For the inorganic oxide porous medium used in the present invention, there can be cited a porous medium such as a titanium oxide, a tin oxide, a tungsten oxide, a zinc oxide, an indium oxide, a niobium oxide, an iron oxide, a nickel oxide, a cobalt oxide, a strontium oxide, a tantalum oxide, an antimony oxide, a lanthanoid oxide, a yttrium oxide, a vanadium oxide and the like, but it is not limited only by those if it is a porous medium in which it becomes possible for the photoelectric conversion to be performed up to a visible light region and/or a near-infrared light region depending on a fact that the surface thereof adsorbs the sensitizing dye. In order that the surface of the inorganic oxide porous medium is sensitized by the sensitizing dye, it is preferable for the conduction band of the inorganic oxide to exist at a position in which it is easy to receive electrons from the photo-excitation energy level of the sensitizing dye. For this reason, even within the aforesaid inorganic oxide porous media, particularly, there will be used a titanium oxide, a tin oxide, a zinc oxide, a niobium oxide or the like. Further, particularly, there will be used a titanium oxide from a view point of cost, environmental sanitation or the like. In the present invention, it is possible, from aforesaid inorganic oxide porous media, to use one kind thereof or to select a plurality of kinds thereof for using them by being combined.

There will be cited examples hereinafter and the present exemplified embodiment will be explained specifically, but the present exemplified embodiment would not be limited by those at all.

[Example 1]

-Forming of Photoelectric Conversion Layer-

A titania paste Ti-Nanoxide T/SP manufactured by Solaronixs Corp. was applied with coating by a screen printing method on a glass substrate with FTO film having surface resistance value of 10Ω/sq whose size is 15mm x 25mm and was dried for 3 minutes by 120°C. The coating-applied substrate was sintered for 30 minutes by 500°C. When the film thickness of the titania semiconductor layer after the sintering was measured by a needle contact type film thickness meter, it was found out that the thickness was 20μm. An acetonitrile solution (concentration: 3mM) of the organic molecule expressed by TCNQ(7, 7, 8, 8-tetracyanoquinodimethane) was prepared and by dipping aforesaid titanium oxide substrate therein for 190 hours, there was formed a photoelectric conversion electrode.

-Evaluation of Photoelectric Conversion Layer-

FIG. 2 is a diagram showing an absorption spectrum (a) of an acetonitrile solution of TCNQ and an absorption spectrum (b) of a titanium oxide after the dipping into the acetonitrile solution. In the drawing, a solid line denotes a diffuse reflection difference spectrum and a broken line denotes an absorption spectrum of the acetonitrile. The absorption spectrum of this titanium oxide was different from the absorption spectrum of the acetonitrile solution of TCNQ and presented an absorption from a visible light region beyond a near-infrared region. It should be noted that since the titanium oxide substrate dipped into the dye solution and colored presented a light-scattering property, the measurement for the absorption spectrum was executed in the following manner. The diffuse reflection spectrum ($R_{TiO2}(\lambda)$) before being dipped into the dye solution was measured by using a self-writing spectrophotometer (V-570 of Jasco Corp.) mounted with an integrating sphere. Similarly, the diffuse reflection spectrum ($R_{TiO2\text{-}dye}(\lambda)$) of the titanium oxide substrate after being dipped into the dye solution was measured. By using those, the absorption spectra were found out from the following equation.

[Mathematical Formula 1]

$$A(\lambda) = -\log\left(\frac{R_{TiO2\text{-}dye}(\lambda)}{R_{TiO2}(\lambda)}\right)$$

-Production of Solar Cell-

Hi-milan (having film thickness of 30μm) was arranged in the circumference of a counter electrode in which Pt was film-formed by a film thickness of 1nm on a glass substrate with an FTO film having two electrolyte solution injection holes whose diameters were 0.7mm, it was coupled with aforesaid light electrode and thereafter, an acetonitrile solution including 2.0mol/L lithium iodide and 0.025mol/L iodine was inserted from aforesaid electrolyte solution injection holes, and a dye-sensitized solar cell was produced.

-Evaluation of Solar Cell Characteristic-

FIG. 3 shows an IPCE spectrum of a photoelectric conversion device using TCNQ. The IPCE (Incident-Photon Conversion Efficiency) of the cell obtained by the method mentioned above was measured in a range from 300nm to 1100nm. As a result thereof, as shown in the drawing, it was possible, from ultraviolet beyond 800nm, to obtain a high IPCE in a region corresponding to the light absorption.

Also, by using a solar simulator, a quasi solar light source (AM1.5, 100mW/cm$^2$) was illuminated and a current-voltage characteristic of the solar cell was measured. The solar cell characteristics obtained are shown in Table 1 and in Table 2 including also cases of other compounds. Although there existed a little fluctuation in the data depending on the measurement time, as shown in the tables, there was obtained a photoelectric conversion efficiency of 2.2% in a case, for example, of TCNQ.

[Table 1]

| Organic Molecule | $J_{SC}$(mA/cm$^2$ ) | $V_{OC}$(V ) | FF | Photoelectric Conversion Efficiency (%) |
|---|---|---|---|---|
| TCNQ | 9.9 | 0.36 | 0.61 | 2.2 |
| TCNE | 3.3 | 0.41 | 0.64 | 0.85 |
| TNCQ-F4 | 3.8 | 0.47 | 0.68 | 1.2 |
| TCNAQ | 7.9 | 0.33 | 0.61 | 1.6 |

[Table 2]

| I-V data | | | | |
|---|---|---|---|---|
| | Conversion Efficiency (%) | $J_{SC}$(mA/cm$^2$) | $V_{OC}$(V) | FF |
| TCNE | 0.85 | 3.3 | 0.41 | 0.64 |
| TCNQ | 2.2 | 9.9 | 0.36 | 0.61 |
| TCNQ-F | 1.8 | 6 | 0.46 | 0.66 |
| TCNQ-$F_2$ | 1.3 | 4.6 | 0.42 | 0.69 |
| TCNQ-$F_4$ | 1.2 | 3.8 | 0.47 | 0.68 |
| TCNQ-$Me_2$ | 2.2 | 7.6 | 0.44 | 0.65 |
| TCNQ-HEO | 1.5 | 4.7 | 0.49 | 0.65 |
| TCNAQ | 1.6 | 7.9 | 0.33 | 0.61 |
| TCB | 0.048 | 0.23 | 0.36 | 0.58 |
| DDQ | 0.101 | 0.566 | 0.294 | 0.607 |

[Example 2]

-Forming of Photoelectric Conversion Layer-

A photoelectric conversion layer was formed similarly as that of the example 1 other than that the organic molecule TCNQ was changed to the organic molecule TCNE. In FIG. 4, there are shown an absorption spectrum (a) of an acetonitrile solution of TCNE and an absorption spectrum (b) of a titanium oxide after the dipping into the acetonitrile solution. In the drawing, a solid line denotes a diffuse reflection difference spectrum and a broken line denotes an absorption spectrum of the acetonitrile. The absorption spectrum of this titanium oxide was different from the absorption spectrum of the acetonitrile solution of TCNE and presented an absorption from a visible region.

-Production of Solar Cell-

A solar cell was produced by a procedure similar to that of the example 1.

-Evaluation of Solar Cell Performance-

The IPCE (Incident-Photon Conversion Efficiency) of the solar cell was measured in a range from 300nm to 1100nm. As a result thereof, as shown in FIG. 5, it was possible, from ultraviolet beyond 700nm, to obtain a high IPCE in a region corresponding to light absorption.

Also, by using a solar simulator, a quasi solar light source (AM1.5, 100mW/cm$^2$) was illuminated and a current-voltage characteristic of the solar cell was measured. With respect to the obtained solar cell, a photoelectric conversion efficiency of 0.85% was obtained.

[Example 3]

-Forming of Photoelectric Conversion Layer-

A photoelectric conversion layer was formed similarly as that of the example 1 other than that the organic molecule TCNQ was changed to the organic molecule TCNQ-$F_4$. In FIG. 6, there are shown an absorption spectrum (a) of an acetonitrile solution of TCNQ-$F_4$ and an absorption spectrum (b) of a titanium oxide after the dipping into the acetonitrile solution. The absorption spectrum of this titanium oxide was different from the absorption spectrum of the acetonitrile solution of TCNQ-$F_4$, and presented absorption from a visible region beyond a near-infrared region.

-Production of Solar Cell-

A solar cell was produced by a procedure similar to that of the example 1.

-Evaluation of Solar Cell Performance-

The IPCE (Incident-Photon Conversion Efficiency) of the solar cell was measured in a range from 300nm to 1100nm. As a result thereof, as shown in FIG. 7, it was possible, from ultraviolet beyond 650nm, to obtain a high IPCE in a region corresponding to light absorption.

Also, by using a solar simulator, a quasi solar light source (AM1.5, 100mW/$cm^2$) was illuminated and a current-voltage characteristic of the solar cell was measured. The obtained solar cell characteristic is shown in Table 1, and a photoelectric conversion efficiency of 1.2% was obtained.

[Example 4]

-Forming of Photoelectric Conversion Layer-

A photoelectric conversion layer was formed similarly as that of the example 1 other than that the organic molecule TCNQ was changed to the organic molecule TCNAQ. In FIG. 8, there are shown an absorption spectrum (a) of an acetonitrile solution of TCNAQ and an absorption spectrum (b) of a titanium oxide after the dipping into the acetonitrile solution. In the drawing, a solid line denotes a diffuse reflection difference spectrum and a broken line denotes an absorption spectrum in the acetonitrile. The absorption spectrum of this titanium oxide was different from the absorption spectrum of the acetonitrile solution of TCNAQ, and presented absorption from a visible region beyond a near-infrared region.

-Production of Solar Cell-

A solar cell was produced by a procedure similar to that of the example 1.

-Evaluation of Solar Cell Performance-

The IPCE (Incident-Photon Conversion Efficiency) of the solar cell was measured in a range from 300nm to 1100nm. As a result thereof, as shown in FIG. 9, there was presented a photoelectric conversion characteristic from ultraviolet beyond approximately 900nm.

Also, by using a solar simulator, a quasi solar light source (AM1.5, 100mW/$cm^2$) was illuminated and a current-voltage characteristic of the solar cell was measured. The obtained solar cell characteristic is shown in Table 1, and a photoelectric conversion efficiency of 1.6% was obtained.

[Example 5]

-Forming of Photoelectric Conversion Layer-

A titania paste Ti-Nanoxide T/SP manufactured by Solaronixs Corp. was applied with coating by a screen printing method on a glass substrate with FTO film having surface resistance value of 10Ω/sq whose size is 15mm x 25mm and was dried for 3 minutes by 120°C. The coating-applied substrate was sintered for 30 minutes by 500°C. When the film thickness of the titania semiconductor layer after the sintering was measured by a needle contact type film thickness meter, it was found out that the thickness was 20μm. An acetonitrile solution (concentration: 3mM) of methyl viologen was prepared and by dipping aforesaid titanium oxide substrate therein for 190 hours, there was formed a photoelectric conversion electrode.

-Evaluation of Photoelectric Conversion Layer-

FIG. 10 shows an absorption spectrum of a titanium oxide after the dipping into the acetonitrile solution of methyl viologen. The absorption spectrum was found out by a method similar to that of the example 1.

-Evaluation of Solar Cell Performance-

FIG. 11 is a diagram showing a result obtained from a fact that the IPCE (Incident-Photon Conversion Efficiency) of the solar cell was measured in a range from 300nm to 1100nm. As a result thereof, as shown in the drawing, it was possible, from ultraviolet beyond 700nm, to obtain a high IPCE in a region corresponding to the light absorption.

FIG. 12 is a diagram showing a result obtained from a fact that a current-voltage characteristic of the solar cell was measured by using a solar simulator and by illuminating a quasi solar light source (AM1.5, 100mW/$cm^2$). With respect to the obtained solar cell, a photoelectric conversion efficiency of 0.1% was obtained.

[Example 6]

-Forming of Photoelectric Conversion Layer-

A titania paste Ti-Nanoxide T/SP manufactured by Solaronixs Corp. was applied with coating by a screen printing method on a glass substrate with FTO film having surface resistance value of 10Ω/sq whose size is 15mm x 25mm and was dried for 3 minutes by 120°C. The coating-applied substrate was sintered for 30 minutes by 500°C. When the film thickness of the titania semiconductor layer after the sintering was measured by a needle contact type film thickness meter, it was found out that the thickness was 20μm. An acetonitrile solution (concentration: 3mM) of chloranil was prepared and by dipping aforesaid titanium oxide substrate therein for 190 hours, there was formed a photoelectric conversion electrode.

-Evaluation of Photoelectric Conversion Layer-

FIG. 13 shows an absorption spectrum of a titanium oxide after the dipping into the acetonitrile solution of chloranil. The absorption spectrum was found out by a method similar to that of the example 1.

-Evaluation of solar cell Performance-

FIG. 14 is a diagram showing a result obtained from a fact that the IPCE (Incident- Photon Conversion Efficiency) of the solar cell was measured in a range from 300nm to 1100nm. As a result thereof, as shown in the drawing, it was possible, from ultraviolet beyond 750nm, to obtain a high IPCE in a region corresponding to the light absorption.
FIG. 15 is a diagram showing a result obtained from a fact that a current-voltage characteristic of the solar cell was measured by using a solar simulator and by illuminating a quasi solar light source (AM1.5, 100mW/$cm^2$). With respect to the obtained solar cell, a photoelectric conversion efficiency of 0.12% was obtained.
[Other Examples]

-Concentration Change of Supporting electrolyte-

FIG. 16 is a diagram showing an IPCE spectrum in case of using TCNQ for an organic compound and changing a supporting electrolyte (lithium iodide) in an electrolyte. As understood from the drawing, there were presented a higher IPCE and a photoelectric conversion characteristic in a wider range of a wavelength region by increasing the concentration of the lithium iodide.

[Ratio Determination between Anatase Type and Rutile Type]

For a titanium oxide, there are crystal structures of an anatase type and a rutile type.
When a molecule including a dicyano group is adsorbed to the anatase type titanium oxide, a wide-range light absorption occurs from a visible region beyond a near-infrared region which are different from the respective absorption regions. On the other hand, in case of the rutile type titanium oxide, such a wide-range light absorption did not occur.
FIG. 17 shows color changes of a titanium oxide before and after the TCNQ absorption with respect to the anatase and rutile types of $TiO_2$. The composition of the dipping solution was TCNQ (neutral) / $CH_3CN$.
FIG. 18 shows color changes when a titanium oxide in which an anatase and a rutile were mixed was dipped into a TCNQ (7, 7, 8, 8-tetracyanoquinodimethane) solution. In the drawing, there is shown a situation in which the TCNQ is adsorbed to each of the test samples whose anatase contents are different one another. The composition of the dipping solution was TCNQ (neutral) / $CH_3CN$. The ratio of the anatase is reflected to the coloring degree. Based on this fact, it will be comprehended about the anatase-rutile dependency.
It is conceivable that the crystal structure of the titanium oxide can be distinguished from the absorption spectra of these solutions. In other words, when measuring the absorption spectra of these solutions carefully, it is conceivable that the ratio between the anatase type and the rutile type can be determined. Also, it is conceivable with respect to these results that it is very excellent to combine the anatase type titanium oxide and the cyano compound mentioned above for realizing a wide-range light absorption.

[Oxidation-Reduction Potential, etc.]

For the metal oxide, a titanium oxide, an anatase type titanium oxide or the like is preferable and, for example, in case of the anatase type titanium oxide, a reduction potential measured based on the electrochemical experimentation becomes approximately -0.7V. Therefore, in case of using a hybrid and/or complex material as a photoelectric conversion material, it is preferable for the reduction potential of an electron acceptable organic molecule measured based on the electrochemical experimentation to be approximately -0.7V or more. Similarly, in order to be adsorbed to the metal oxide

and to form a new substance, an electron transfer is accompanied therewith, so that it is preferable for the electron acceptable organic molecule to have the lowest unoccupied energy level which has a larger energy difference from the vacuum energy level compared with that of the lowest energy level of the electron conductor of aforesaid metal oxide. It should be noted that it is possible for the oxidation-reduction potential to be estimated by dissolving a test sample and a supporting electrolyte (tetrafluoroboric acid tetra-n-butylammonium, etc.) into a solvent (acetonitrile, etc.) and by executing the electric current-voltage measurement by using a working electrode (platinum, etc.), a counter electrode (platinum, etc.) and a reference electrode (saturated calomel electrode, standard hydrogen electrode, silver-silver chloride electrode, etc.).

[Summary]

As mentioned above, according to this exemplified embodiment, it is possible to provide a photoelectric conversion device having a new photoelectric conversion layer which enables more wide-ranging light absorption by using an organic molecule which has a high general-purpose performance and which is in a low cost. Also, by using the photoelectric conversion layer of this exemplified embodiment, it becomes possible to provide a photoelectric conversion device which can be produced highly effectively, and inexpensively for the material cost and for the manufacturing cost. Further, if the anatase type titanium oxide and the cyano compound mentioned above are combined, there can be realized a wide range of light absorption. These matters potentially include possibilities for achieving a large technical contribution when realizing a highly effective photoelectric conversion device, a highly effective solar cell and the like.

[Interpretation of Patent Right, etc.]

As mentioned above, it has been explained with respect to the present invention with reference to specific exemplified examples. However, it is just obvious that a person skilled in the art can achieve modification or substitution of the exemplified example within the scope thereof without departing from the gist of the present invention. More specifically, the present invention has been disclosed in a style of exemplification, so that the described contents of the present description must not be interpreted limitedly. In order to evaluate the gist of the present invention, the column of the claims described in the beginning should be taken into consideration.

Also, it is clear that the exemplified examples for the explanation of this invention will achieve the object mentioned above and on the other hand, it would be also understood that a person skilled in the art can employ a lot of modifications or other examples. It is also allowed to employ the element or the component in the scope of the claims, in the specification, in the drawings and in the respective exemplified examples together with another one or a combination thereof. The scope of the claims is intended to cover also such a modification and another exemplified example within that scope, and those are included within the technical idea and the technical scope of this invention.

## Claims

1. In a hybrid and/or complex material in which a compound or its reductant expressed by any one of general formulas from (1) to (13C) mentioned below is adsorbed to a metal oxide, a hybrid and/or complex material, **characterized in that** absorption can be observed in a region of wavelengths different from absorption spectrum that is observed in a region from ultraviolet ray to near-infrared ray presented by said compound which is not adsorbed to said metal oxide.

[Chemical Formula 1]

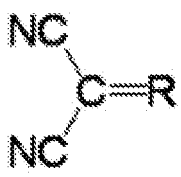

(1)

wherein R denotes a fatty series group, an aromatic group or a heterocyclic group;

[Chemical Formula 2]

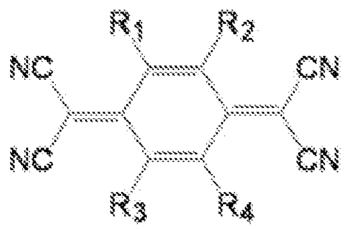

(2)

wherein R1 to R4 may be the same or different one another and
any one thereof denotes one of a hydrogen atom, a fatty series group, an aromatic group, a heterocyclic group and a halogen group in which any one of those may be substituted by a substituent group;

[Chemical Formula 3]

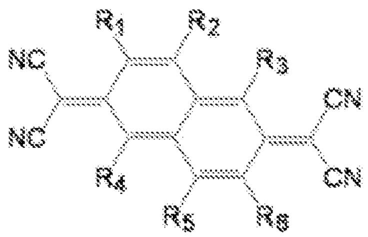

(3)

wherein R1 to R6 may be the same or different one another and any one thereof denotes one of a hydrogen atom, a fatty series group, an aromatic group, a heterocyclic group and a halogen group in which any one of those may be substituted by a substituent group;

[Chemical Formula 4]

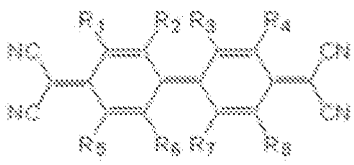

(4)

wherein $R_1$ to $R_8$ may be the same or different one another and any one thereof denotes one of a hydrogen atom, a fatty series group, an aromatic group, a heterocyclic group and a halogen group in which any one of those may be substituted by a substituent group;

[Chemical Formula 5]

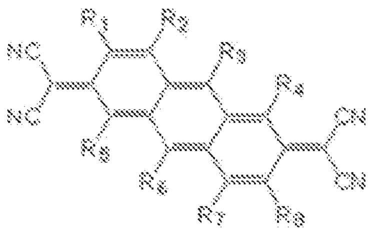

(5)

wherein $R_1$ to $R_8$ may be the same or different one another and any one thereof denotes one of a hydrogen atom, a fatty series group, an aromatic group, a heterocyclic group and a halogen group in which any one of those may be substituted by a substituent group;

[Chemical Formula 6]

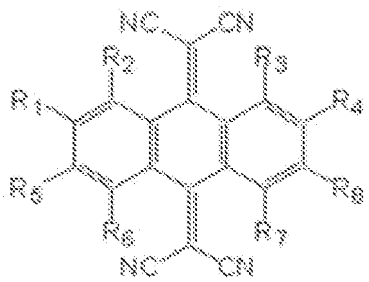

(6)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 7]

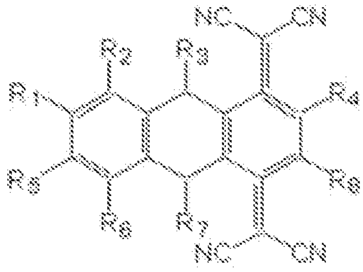

(7)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 8]

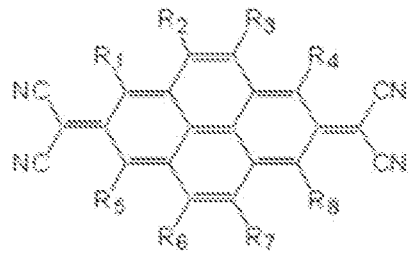

(8)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 9]

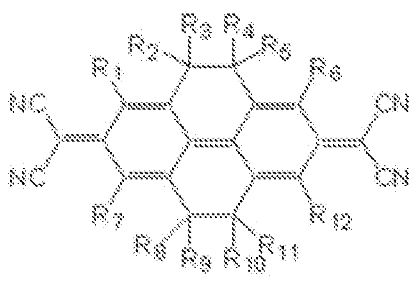

(9)

wherein R1 to R12 may be the same or different one another and any one thereof denotes one of a hydrogen atom, a fatty series group, an aromatic group, a heterocyclic group and a halogen group in which any one of those may be substituted by a substituent group;

[Chemical Formula 10]

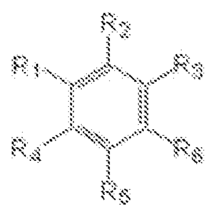

(10)

wherein R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 11]

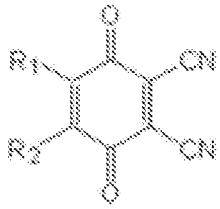

(11)

wherein R1, R2 may be the same or different mutually and any one thereof denotes one of a hydrogen atom, a fatty series group, an aromatic group, a heterocyclic group and a halogen group in which any one of those may be substituted by a substituent group;

[Chemical Formula 12]

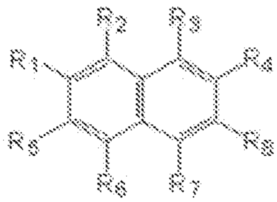

(12)

wherein R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13]

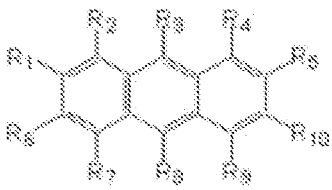

(13)

wherein R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13A]

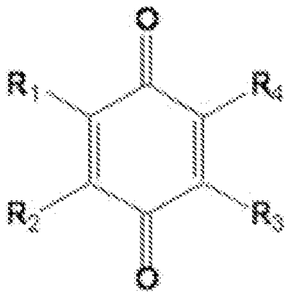

(13A)

wherein R1 to R4 may be the same or different one another and any one thereof denotes one of a hydrogen atom, a fatty series group, an aromatic group, a heterocyclic group and a halogen group in which any one of those may be substituted by a substituent group;

[Chemical Formula 13B]

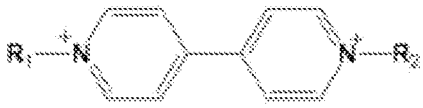

(13B)

wherein R1, R2 may be the same or different mutually and any one thereof denotes one of a hydrogen atom, a fatty series group, an aromatic group, a heterocyclic group and a halogen group in which any one of those may be substituted by a substituent group; and

$C_{60}$ (13C)

wherein $C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.

2. The hybrid and/or complex material according to claim 1, **characterized in that** each of the carbon number of the fatty series group of the substituent group, the carbon number of the aromatic group and the carbon number of the heterocyclic group in the general formulas from (1) to (13C) is 30 or less.

3. A hybrid and/or complex material, **characterized in that** a compound or its reductant expressed by any one of formulas from (i) to (xvi) mentioned below is adsorbed to a metal oxide.

[Chemical Formulas 14]

(i) 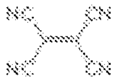 (v) 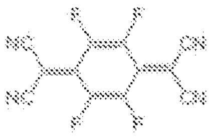 (ix) 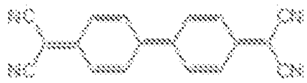

(ii) 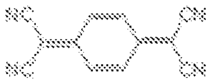 (vi) 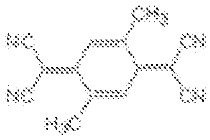 (x) 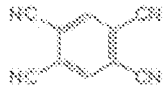

(iii) 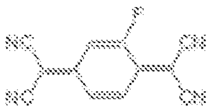 (vii) 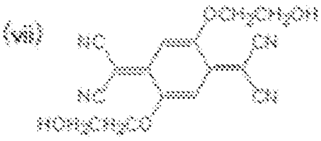 (xi) 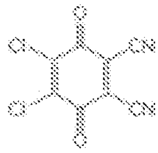

(iv) 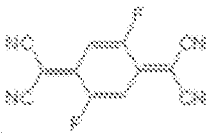 (viii) 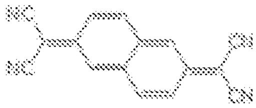 (xii) 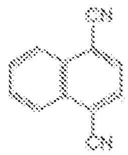

(xiii) 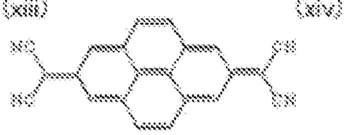 (xiv) 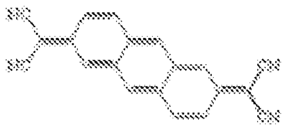 (xv) 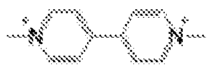 (xvi) 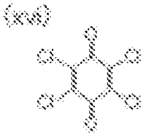

4. A hybrid and/or complex material, **characterized in that** a compound or its reductant expressed by any one of formulas from (a) to (f) mentioned below is adsorbed to a metal oxide.

[Chemical Formulas 15]

(a) 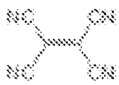 (c) 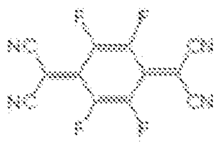 (e) 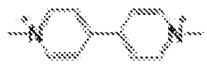

(b) 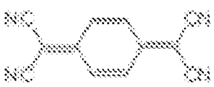 (d) 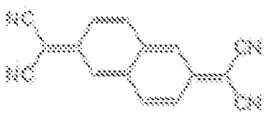 (f) 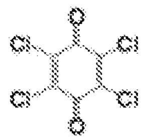

5. A hybrid and/or complex material according to claim 1, **characterized in that** said metal oxide is a titanium oxide.

6. A hybrid and/or complex material according to claim 1, **characterized in that** said metal oxide is an anatase type titanium oxide.

7. In a hybrid and/or complex material in which a compound or its reductant expressed by any one of general formulas from (1) to (13C) mentioned below is adsorbed to a semiconductor, a hybrid and/or complex material, **characterized in that** absorption can be observed in a region of wavelengths different from absorption spectrum that is observed in a region from ultraviolet ray to near-infrared ray presented by said compound which is not adsorbed to said semiconductor.

[Chemical Formula 1]

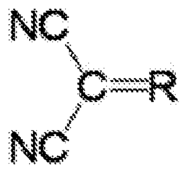

(1)

wherein R denotes a fatty series group, an aromatic group or a heterocyclic group;

[Chemical Formula 2]

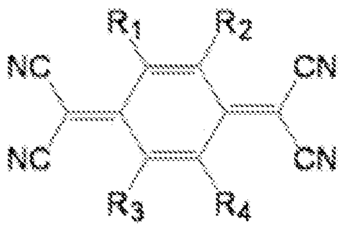

(2)

wherein R1 to R4 may be the same or different one another and any one thereof denotes one of a hydrogen atom, a fatty series group, an aromatic group, a heterocyclic group and a halogen group in which any one of those may be substituted by a substituent group;

[Chemical Formula 3]

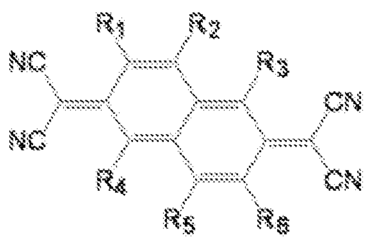

(3)

wherein R1 to R6 may be the same or different one another and any one thereof denotes one of a hydrogen atom, a fatty series group, an aromatic group, a heterocyclic group and a halogen group in which any one of those may be substituted by a substituent group;

[Chemical Formula 4]

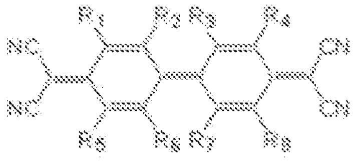

(4)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 5]

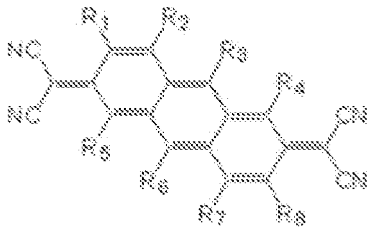

(5)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 6]

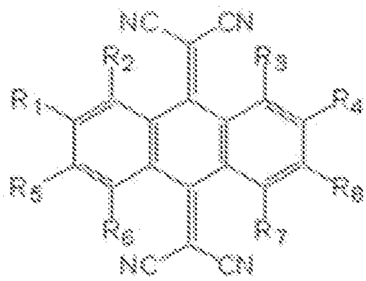

(6)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 7]

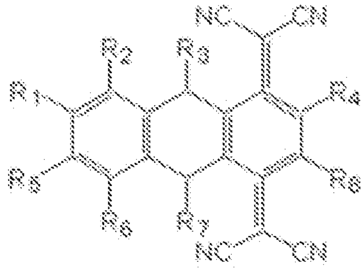

(7)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 8]

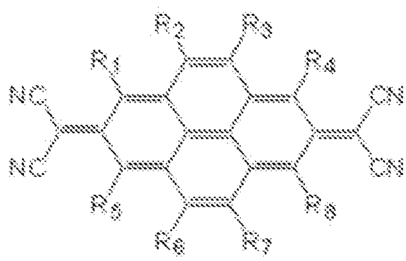

(8)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 9]

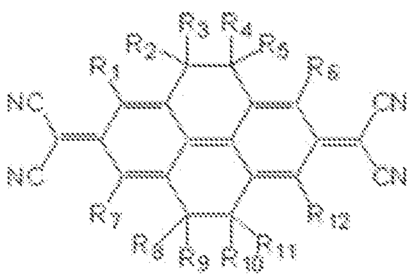

(9)

wherein R1 to R12 may be the same or different one another and any one thereof denotes one of a hydrogen atom, a fatty series group, an aromatic group, a heterocyclic group and a halogen group in which any one of those may be substituted by a substituent group;

[Chemical Formula 10]

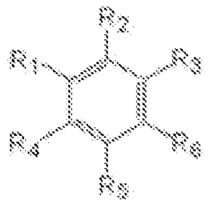

(10)

wherein R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 11]

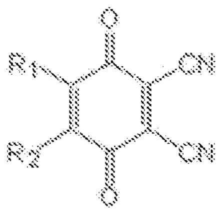

(11)

wherein R1, R2 may be the same or different mutually and any one thereof denotes one of a hydrogen atom, a fatty series group, an aromatic group, a heterocyclic group and a halogen group in which any one of those may be substituted by a substituent group;

[Chemical Formula 12]

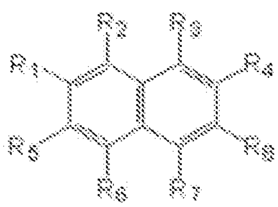

(12)

wherein R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13]

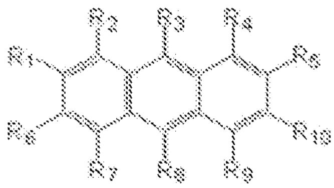

(13)

wherein R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13A]

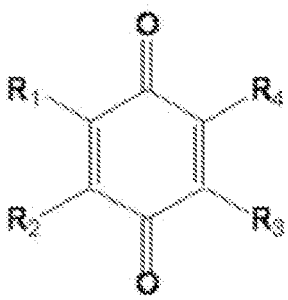

(13A)

wherein R1 to R4 may be the same or different one another and any one thereof denotes one of a hydrogen atom, a fatty series group, an aromatic group, a heterocyclic group and a halogen group in which any one of those may be substituted by a substituent group;

[Chemical Formula 13B]

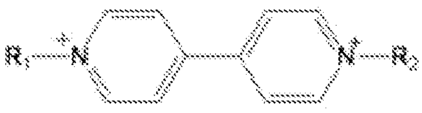

(13B)

wherein R1, R2 may be the same or different mutually and any one thereof denotes one of a hydrogen atom, a fatty series group, an aromatic group, a heterocyclic group and a halogen group in which any one of those may be substituted by a substituent group; and

$C_{60}$ (13C)

wherein $C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.

**8.** A photoelectric conversion material including a hybrid and/or complex material according to any one claim from claim 1 to claim 7.

**9.** A dye-sensitized solar cell including a hybrid and/or complex material according to any one claim from claim 1 to claim 7.

**10.** A dye-sensitized solar cell device, **characterized by** comprising:

a first substrate;
a first conductive layer formed on said first substrate;
a Pt catalyst layer formed on said first conductive layer;
an electrolyte layer formed on said Pt catalyst layer;
a dye-adsorbed metal oxide layer formed on said electrolyte layer in which 7, 7, 8, 8-tetracyanoquinodimethane is adsorbed to anatase type titanium oxide;
a second conductive layer formed on said dye-adsorbed metal oxide layer; and
a second substrate formed on said second conductive layer.

**11.** Manufacturing method of a photoelectric conversion device comprising:

a process for adsorbing a compound or its reductant expressed by any one of general formulas from (1) to (13C) mentioned below to a metal oxide and for forming a dye-adsorbed metal oxide layer; and
a process for arranging said dye-adsorbed metal oxide layer between two pieces of electrodes, wherein absorption of said dye-adsorbed metal oxide layer can be observed in a region of wavelengths different from absorption spectrum that is observed in a region from ultraviolet ray to near-infrared ray presented by said compound which is not adsorbed to said metal oxide.

[Chemical Formula 1]

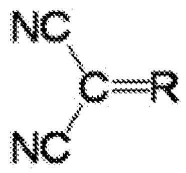

(1)

wherein R denotes a fatty series group, an aromatic group or a heterocyclic group;

[Chemical Formula 2]

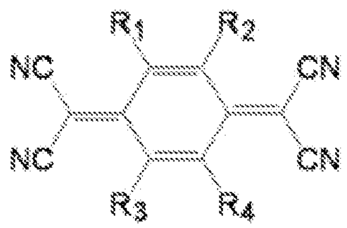

(2)

wherein R1 to R4 may be the same or different one another and any one thereof denotes one of a hydrogen atom, a fatty series group, an aromatic group, a heterocyclic group and a halogen group in which any one of those may be substituted by a substituent group;

[Chemical Formula 3]

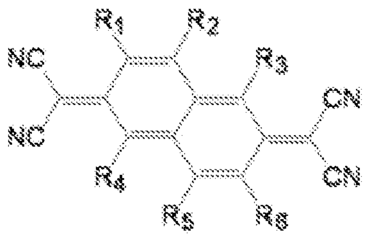

(3)

wherein R1 to R6 may be the same or different one another and any one thereof denotes one of a hydrogen atom, a fatty series group, an aromatic group, a heterocyclic group and a halogen group in which any one of those may be substituted by a substituent group;

[Chemical Formula 4]

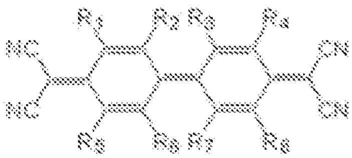

(4)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 5]

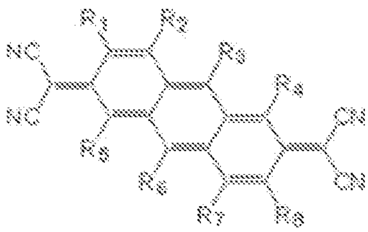

(5)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 6]

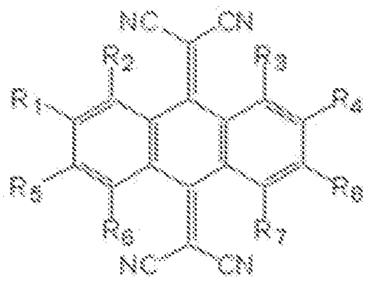

(6)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 7]

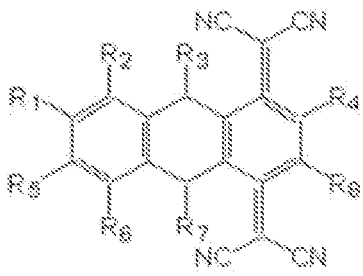

(7)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 8]

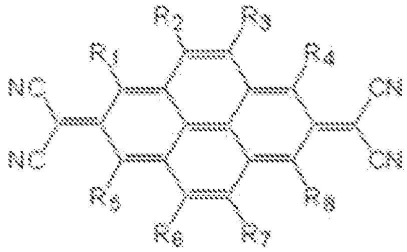

(8)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 9]

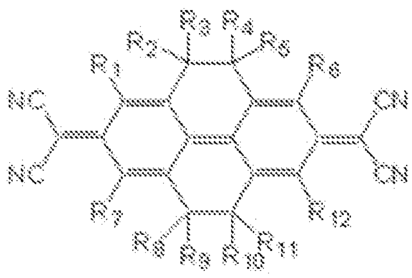

(9)

wherein R1 to R12 may be the same or different one another and any one thereof denotes one of a hydrogen atom, a fatty series group, an aromatic group, a heterocyclic group and a halogen group in which any one of those may be substituted by a substituent group;

[Chemical Formula 10]

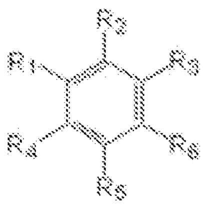

(10)

wherein R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 11]

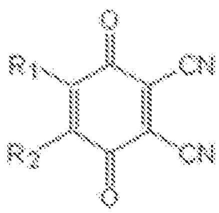

(11)

wherein R1, R2 may be the same or different mutually and any one thereof denotes one of a hydrogen atom, a fatty series group, an aromatic group, a heterocyclic group and a halogen group in which any one of those may be substituted by a substituent group;

[Chemical Formula 12]

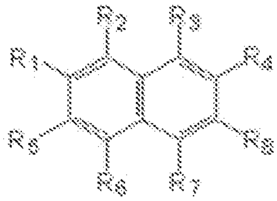

(12)

wherein R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13]

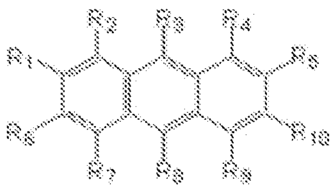

(13)

wherein R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13A]

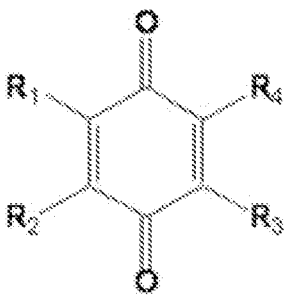

(13A)

wherein R1 to R4 may be the same or different one another and any one thereof denotes one of a hydrogen atom, a fatty series group, an aromatic group, a heterocyclic group and a halogen group in which any one of those may be substituted by a substituent group;

[Chemical Formula 13B]

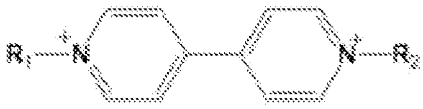 (13B)

wherein R1, R2 may be the same or different mutually and any one thereof denotes one of a hydrogen atom, a fatty series group, an aromatic group, a heterocyclic group and a halogen group in which any one of those may be substituted by a substituent group; and

$C_{60}$ (13C)

wherein $C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.

**12.** A titanium oxide crystal structure analyzing method, **characterized by** obtaining information of the crystal structure of said titanium oxide by adsorbing a compound or its reductant expressed by any one of general formulas from (1) to (13C) mentioned below to a titanium oxide.

[Chemical Formula 1]

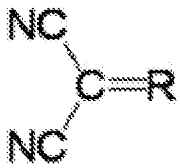 (1)

wherein R denotes a fatty series group, an aromatic group or a heterocyclic group;

[Chemical Formula 2]

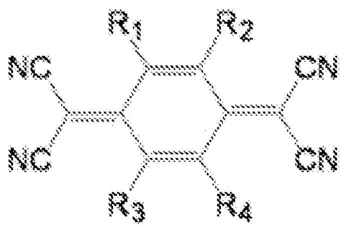 (2)

wherein R1 to R4 may be the same or different one another and any one thereof denotes one of a hydrogen atom, a fatty series group, an aromatic group, a heterocyclic group and a halogen group in which any one of those may be substituted by a substituent group;

[Chemical Formula 3]

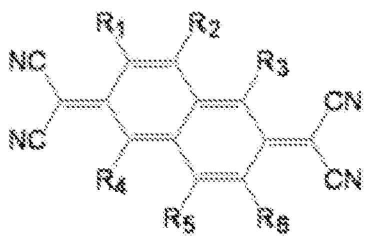

(3)

wherein R1 to R6 may be the same or different one another and any one thereof denotes one of a hydrogen atom, a fatty series group, an aromatic group, a heterocyclic group and a halogen group in which any one of those may be substituted by a substituent group;

[Chemical Formula 4]

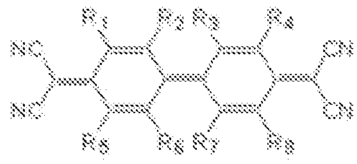

(4)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 5]

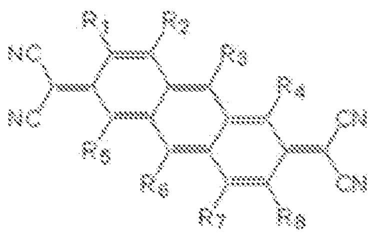

(5)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 6]

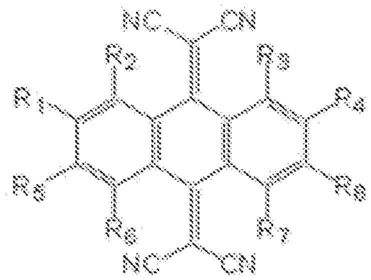

(6)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 7]

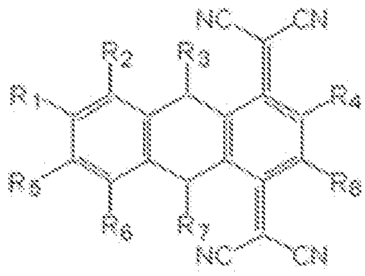

(7)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 8]

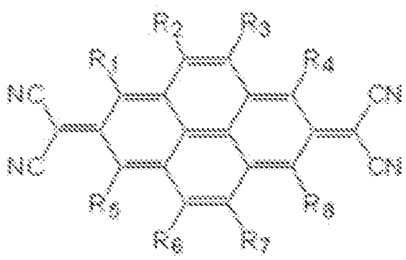

(8)

wherein R1 to R8 may be the same or different one another and any one thereof denotes one of a hydrogen atom, a fatty series group, an aromatic group, a heterocyclic group and a halogen group in which any one of those may be substituted by a substituent group;

[Chemical Formula 9]

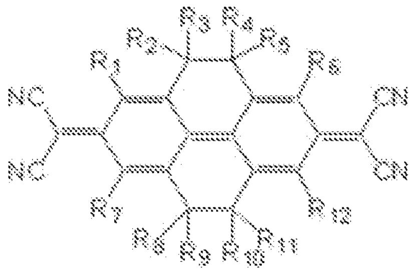

(9)

wherein R1 to R12 may be the same or different one another and any one thereof denotes one of a hydrogen atom, a fatty series group, an aromatic group, a heterocyclic group and a halogen group in which any one of those may be substituted by a substituent group;

[Chemical Formula 10]

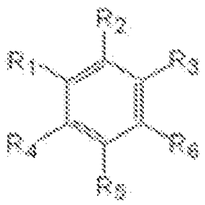

(10)

wherein R1 to R6 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 11]

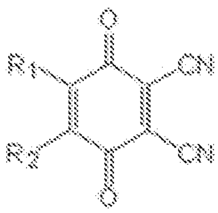

(11)

wherein R1, R2 may be the same or different mutually and any one thereof denotes one of a hydrogen atom, a fatty series group, an aromatic group, a heterocyclic group and a halogen group in which any one of those may be substituted by a substituent group;

[Chemical Formula 12]

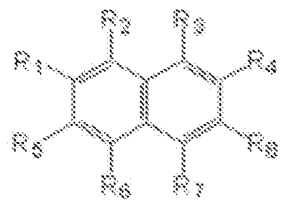

(12)

wherein R1 to R8 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13]

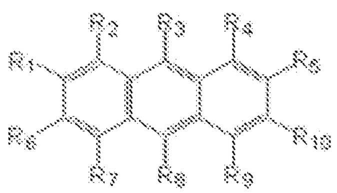

(13)

wherein R1 to R10 may be the same or different one another and any one thereof denotes one of a hydrogen atom, a fatty series group, an aromatic group, a heterocyclic group and a halogen group in which any one of those may be substituted by a substituent group but has one or more cyano groups;

[Chemical Formula 13A]

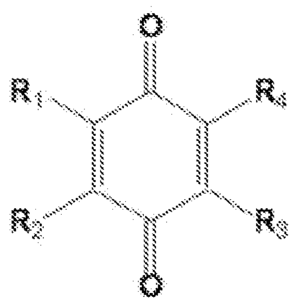

(13A)

wherein R1 to R4 may be the same or different one another and any one thereof denotes one of a hydrogen atom, a fatty series group, an aromatic group, a heterocyclic group and a halogen group in which any one of those may be substituted by a substituent group;

[Chemical Formula 13B]

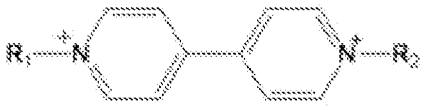 (13B)

wherein R1, R2 may be the same or different mutually and any one thereof denotes one of a hydrogen atom, a fatty series group, an aromatic group, a heterocyclic group and a halogen group in which any one of those may be substituted by a substituent group; and

$C_{60}$ (13C)

wherein $C_{60}$ is a fullerene molecule in which substituent groups may be combined with the fullerene molecule and the substituent groups thereof may be the same or different one another and any one thereof denotes one of a hydrogen atom, a fatty series group, an aromatic group, a heterocyclic group and a halogen group in which any one of those may be substituted by a substituent group.

**13.** In a hybrid and/or complex material in which an electron acceptable organic molecule is adsorbed to a metal oxide, a hybrid and/or complex material, **characterized in that**
said electron acceptable organic molecule has the lowest unoccupied energy level which has a larger energy difference from of the lowest electron conducting energy level of the electron conductor of said metal oxide, and
absorption can be observed in a region of wavelengths different from absorption spectrum that is observed in a region from ultraviolet ray to near-infrared ray presented by said electron acceptable organic molecule which is not adsorbed to said metal oxide.

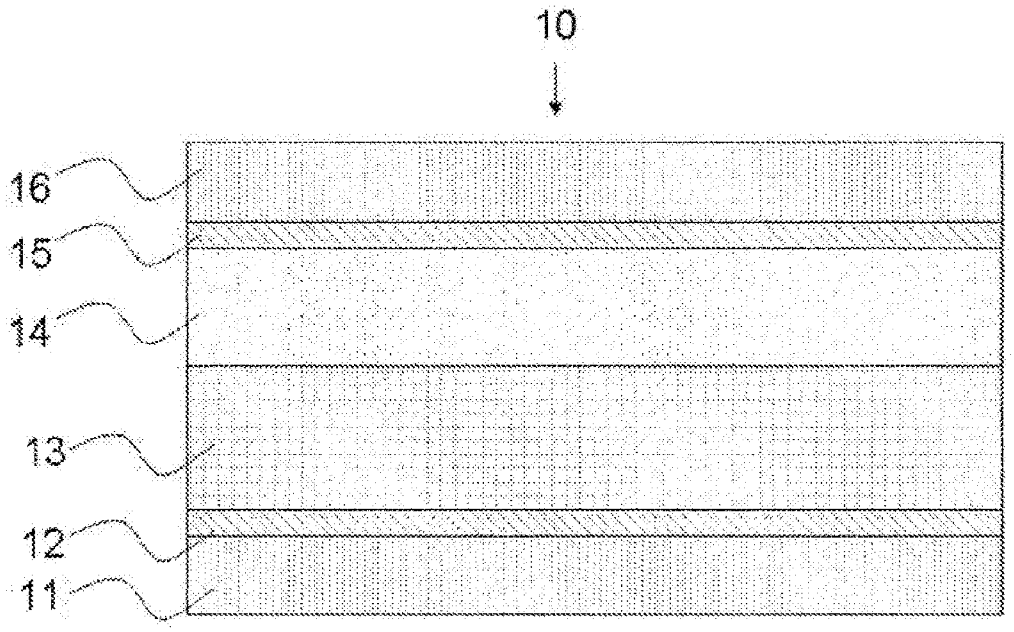
10
16
15
14
13
12
11

Fig. 1

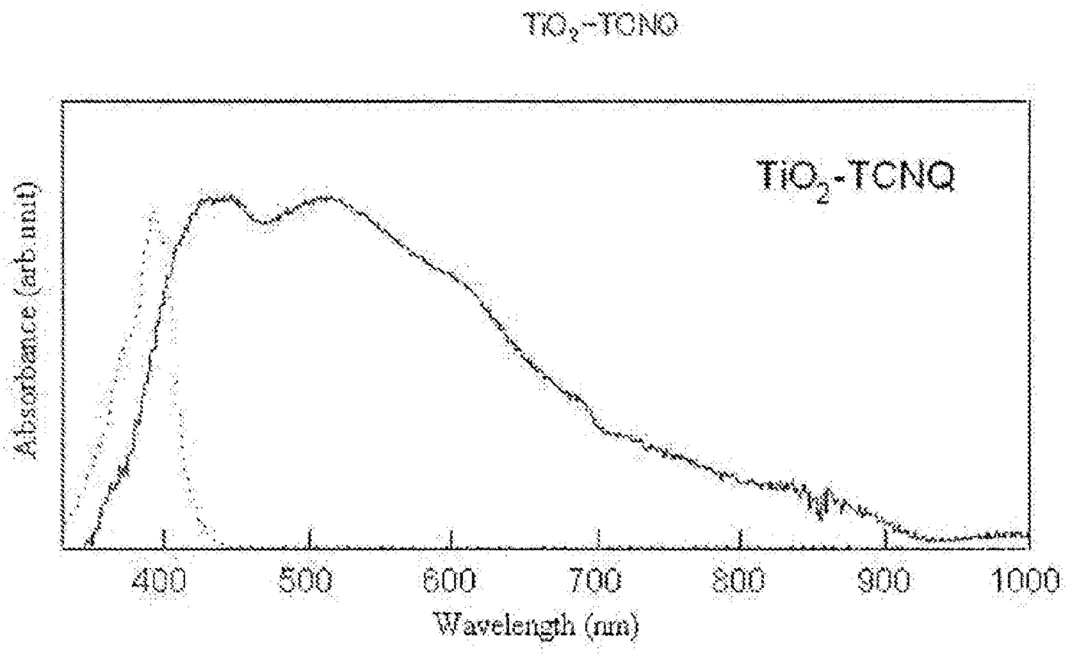
TiO2-TCNQ
TiO2-TCNQ
Absorbance (arb.unit)
400
500
600
700
800
900
1000
Wavelength (nm)

Fig. 2

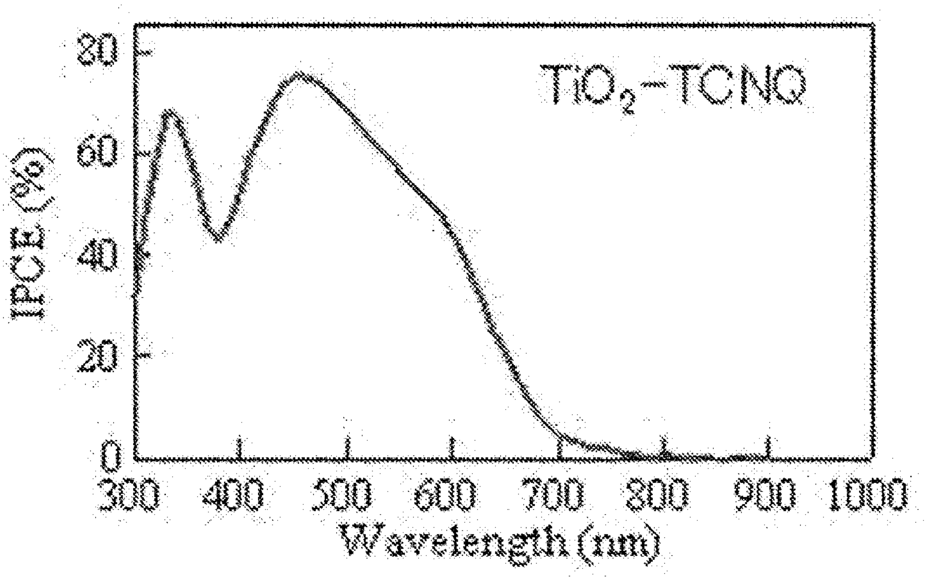

TiO2-TCNQ
IPCE (%)
0
20
40
60
80
300
400
500
600
700
800
900
1000
Wavelength (nm)


Fig. 3

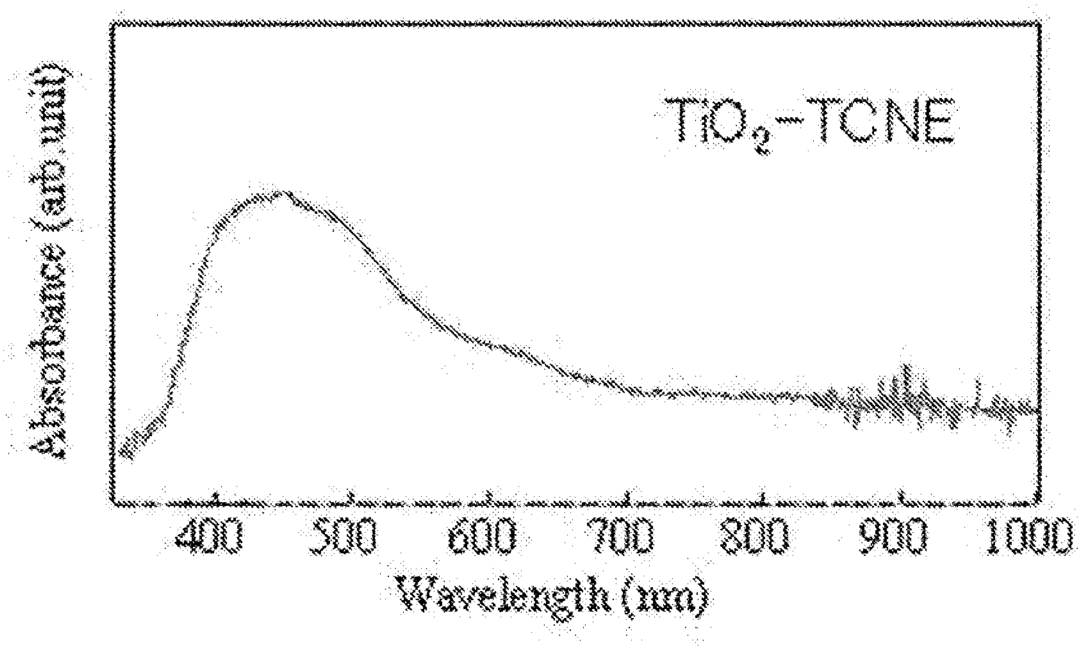

TiO2-TCNE
Absorbance (arb.unit)
400
500
600
700
800
900
1000
Wavelength (nm)


Fig. 4

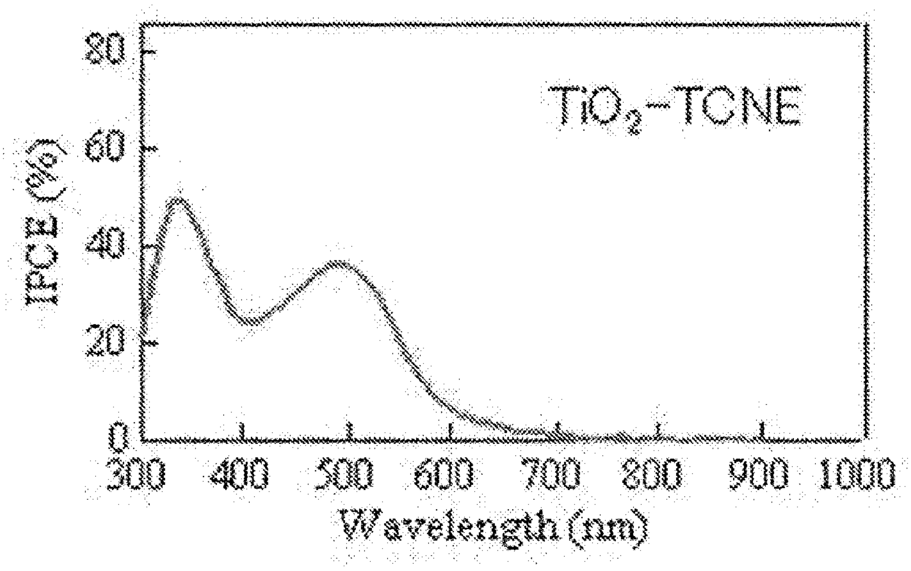
TiO2-TCNE
IPCE (%)
0
20
40
60
80
300
400
500
600
700
800
900
1000
Wavelength (nm)

Fig. 5

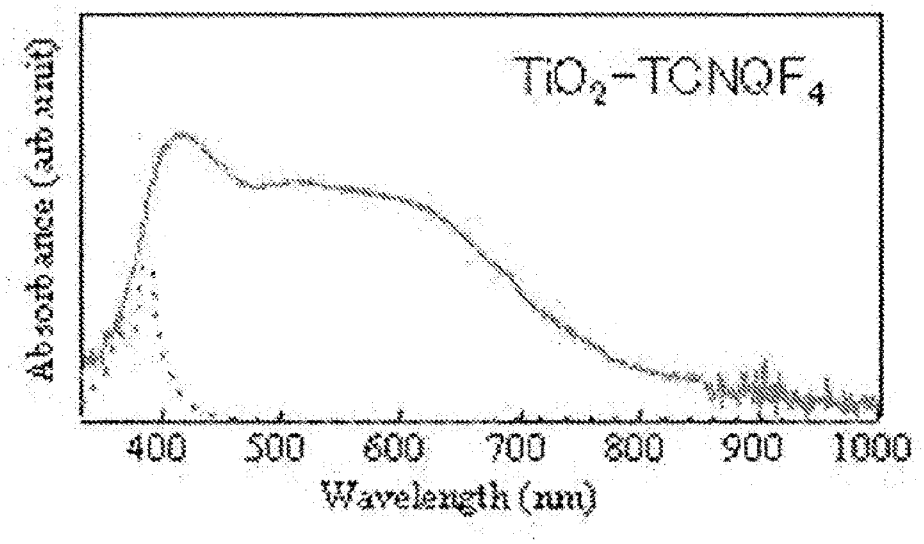
TiO2-TCNQF4
Absorbance (arb.unit)
400
500
600
700
800
900
1000
Wavelength (nm)

Fig. 6

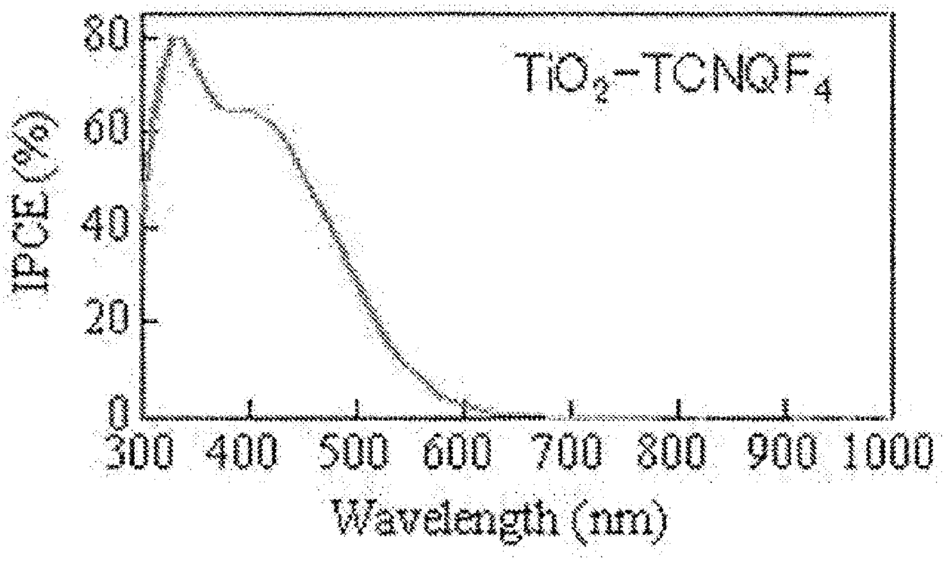
TiO2-TCNQF4
IPCE (%)
80
60
40
20
0
300 400 500 600 700 800 900 1000
Wavelength (nm)

Fig. 7

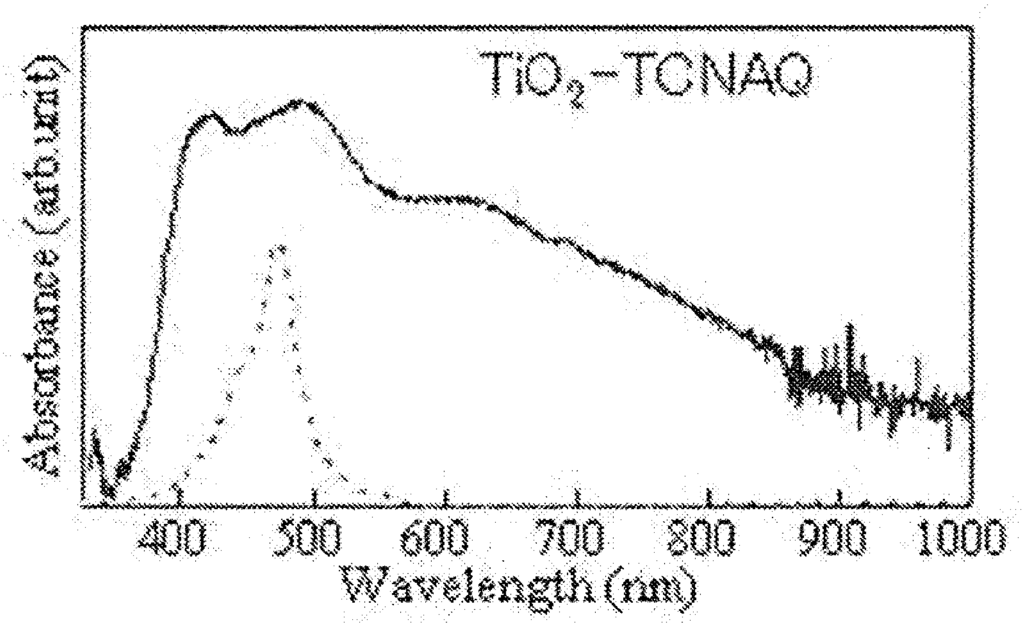
TiO2-TCNAQ
Absorbance (arb. unit)
400 500 600 700 800 900 1000
Wavelength (nm)

Fig. 8

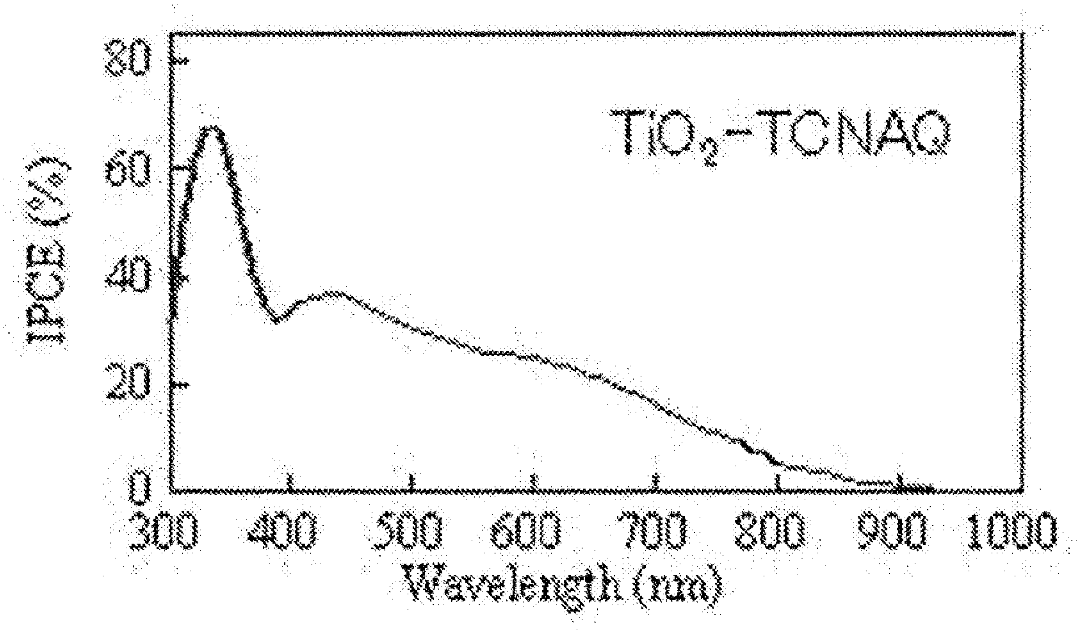
TiO$_2$-TCNAQ
IPCE (%)
0
20
40
60
80
300
400
500
600
700
800
900
1000
Wavelength (nm)

Fig. 9

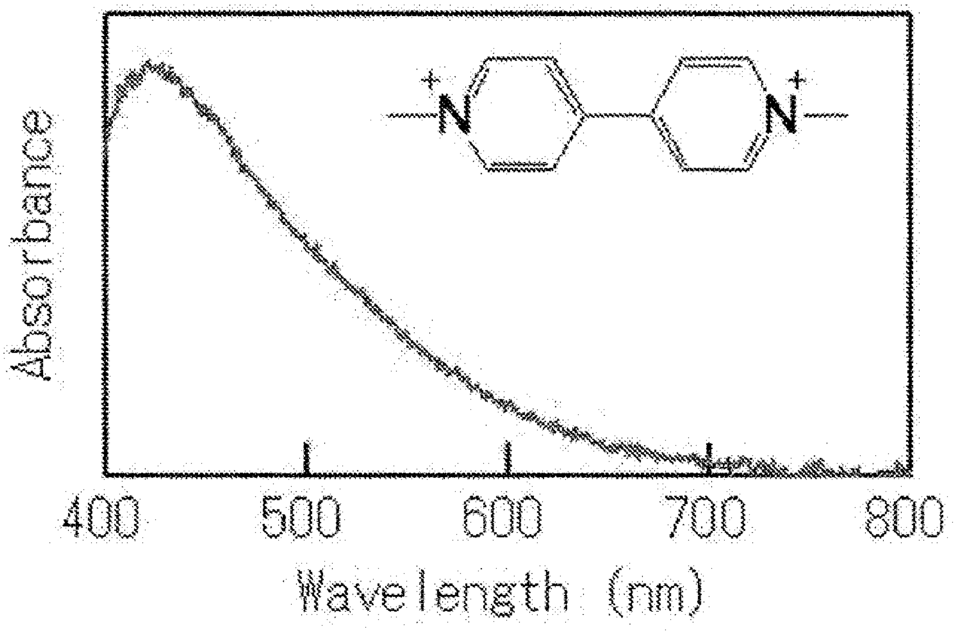
Absorbance
400
500
600
700
800
Wavelength (nm)

Fig. 10

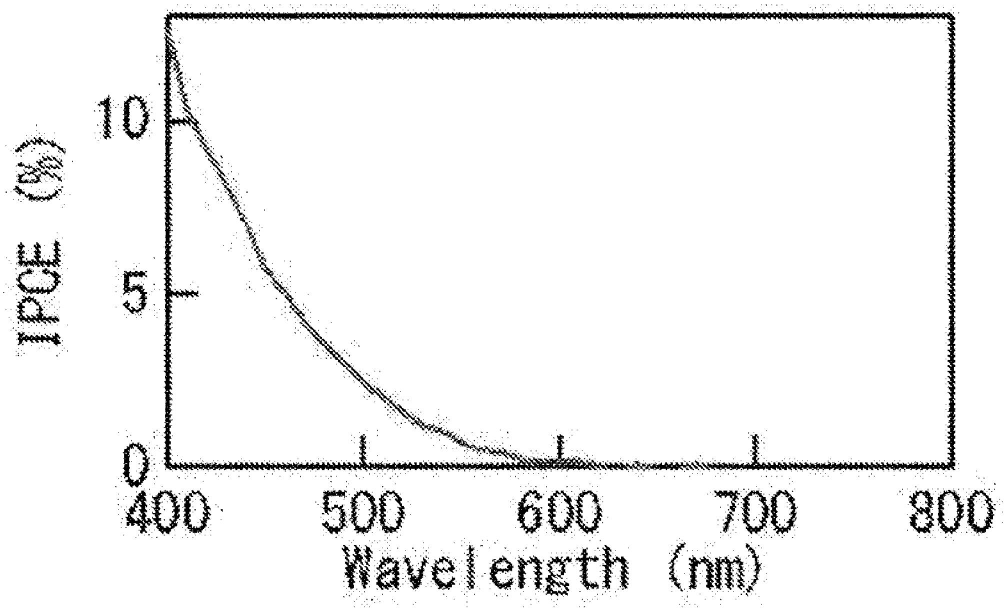
IPCE (%)
10
5
0
400
500
600
700
800
Wavelength (nm)

Fig. 11

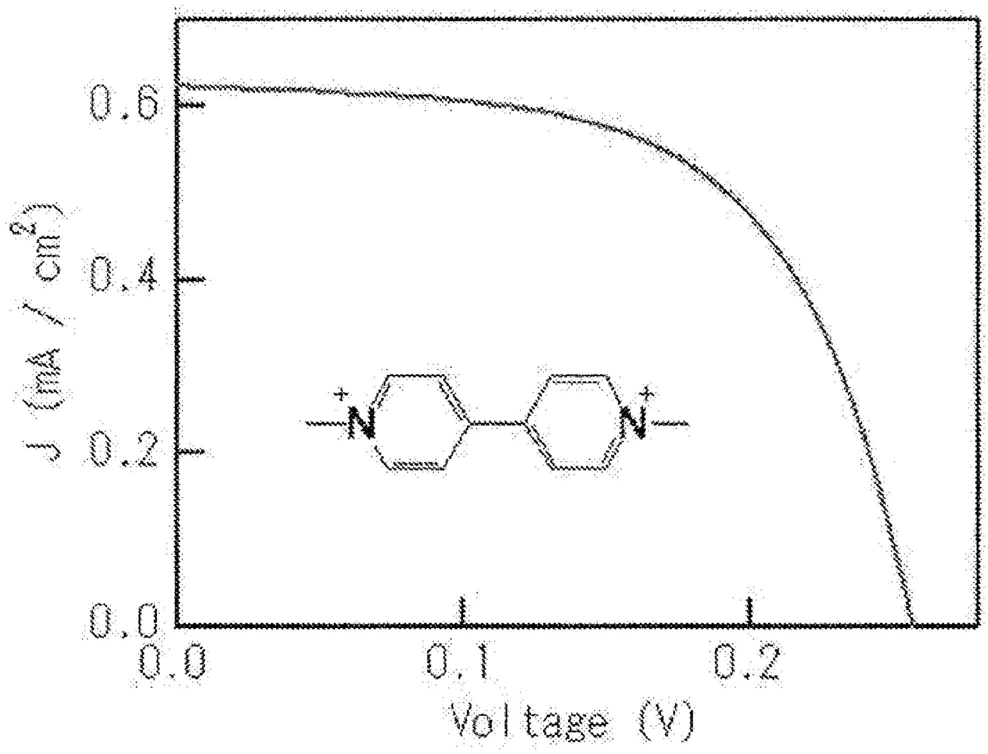
J (mA / cm2)
0.6
0.4
0.2
0.0
0.0
0.1
0.2
Voltage (V)

Fig. 12

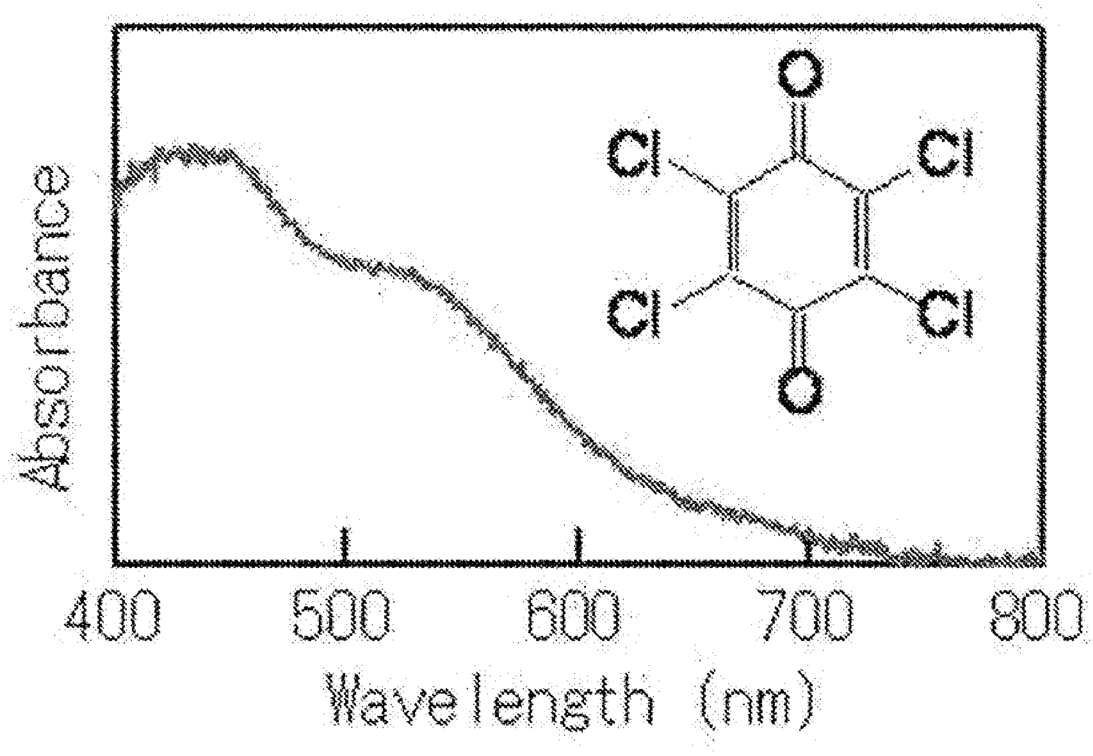
Absorbance
400
500
600
700
800
Wavelength (nm)

Fig. 13

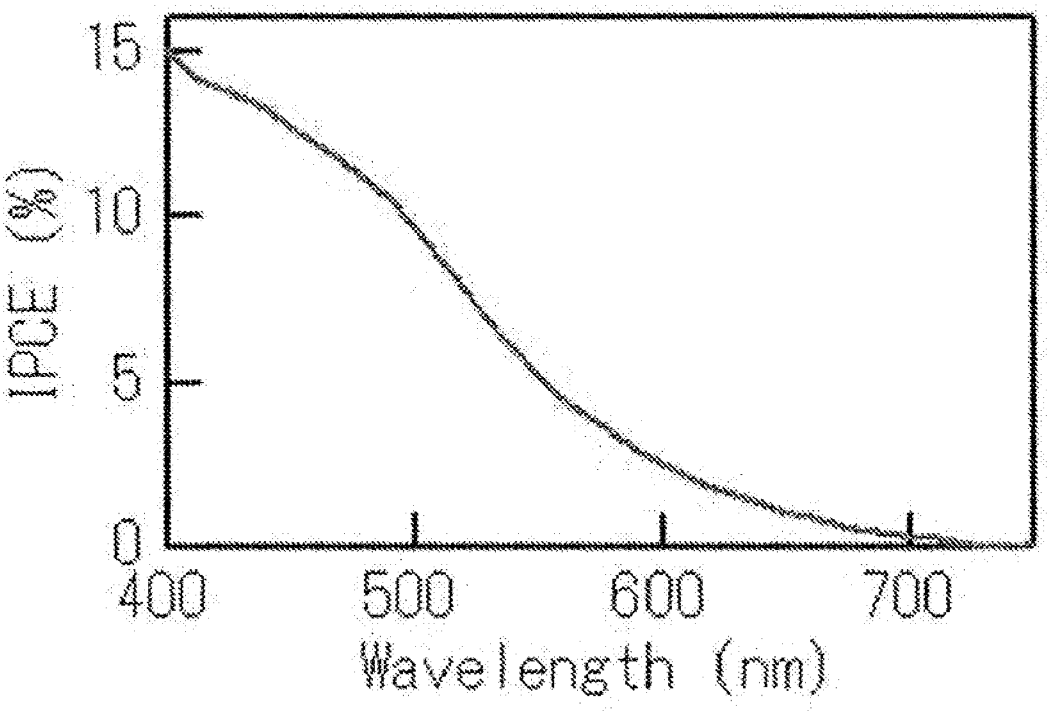
IPCE (%)
15
10
5
0
400
500
600
700
Wavelength (nm)

Fig. 14

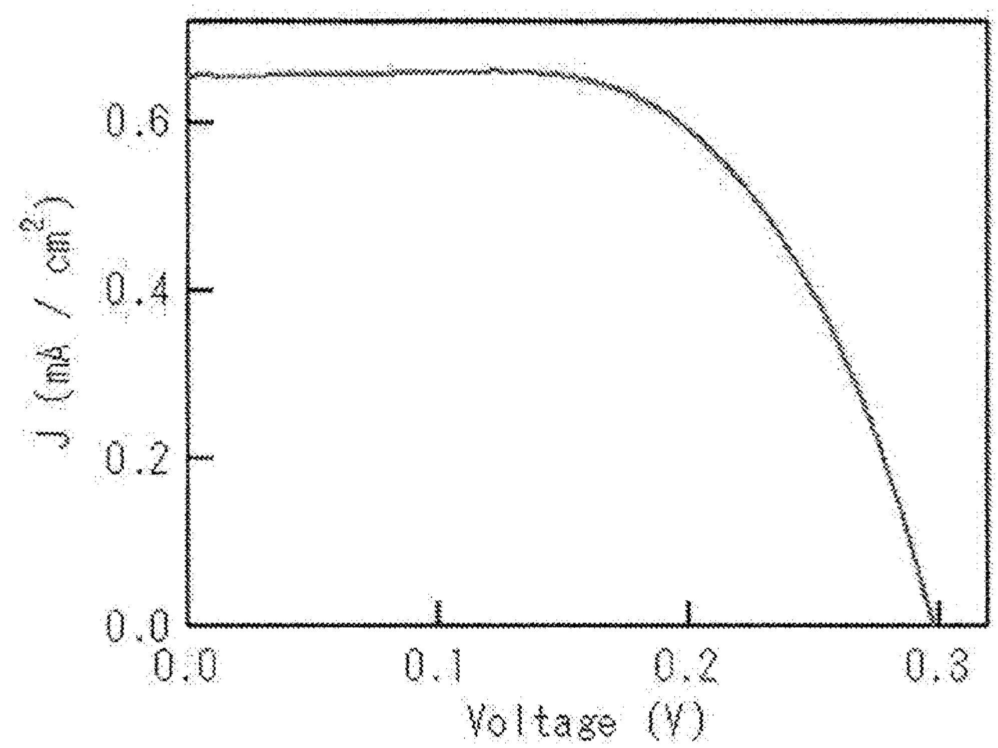


Fig. 15

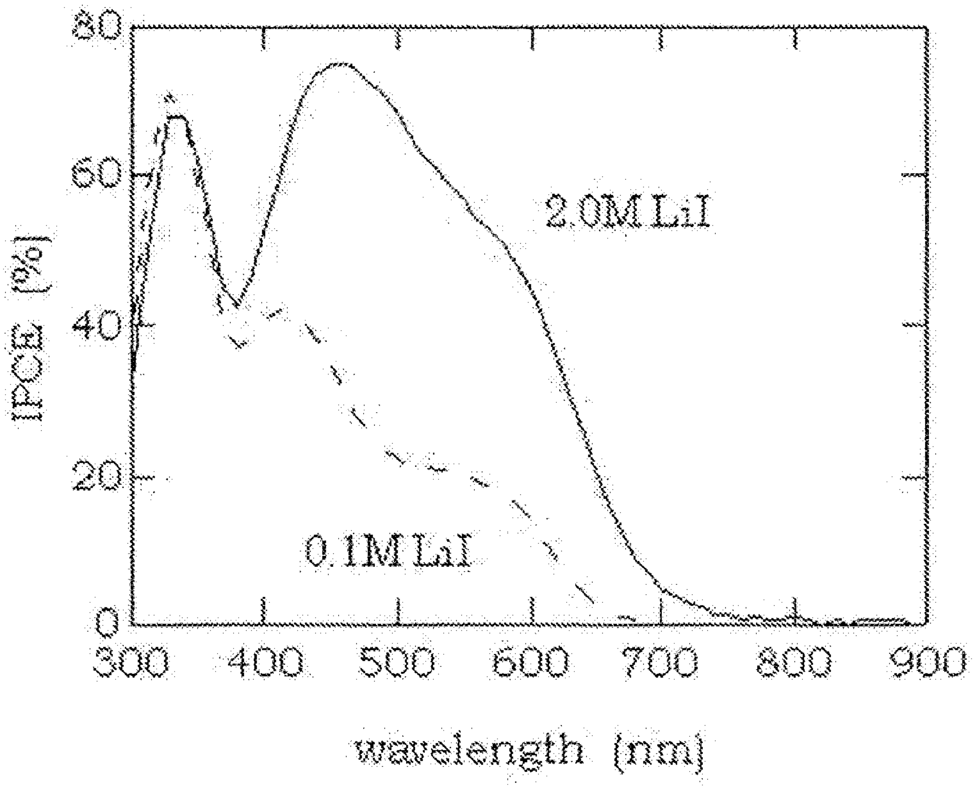
80
60
40
20
0
IPCE [%]
300
400
500
600
700
800
900
wavelength (nm)
2.0M LiI
0.1M LiI

Fig. 16

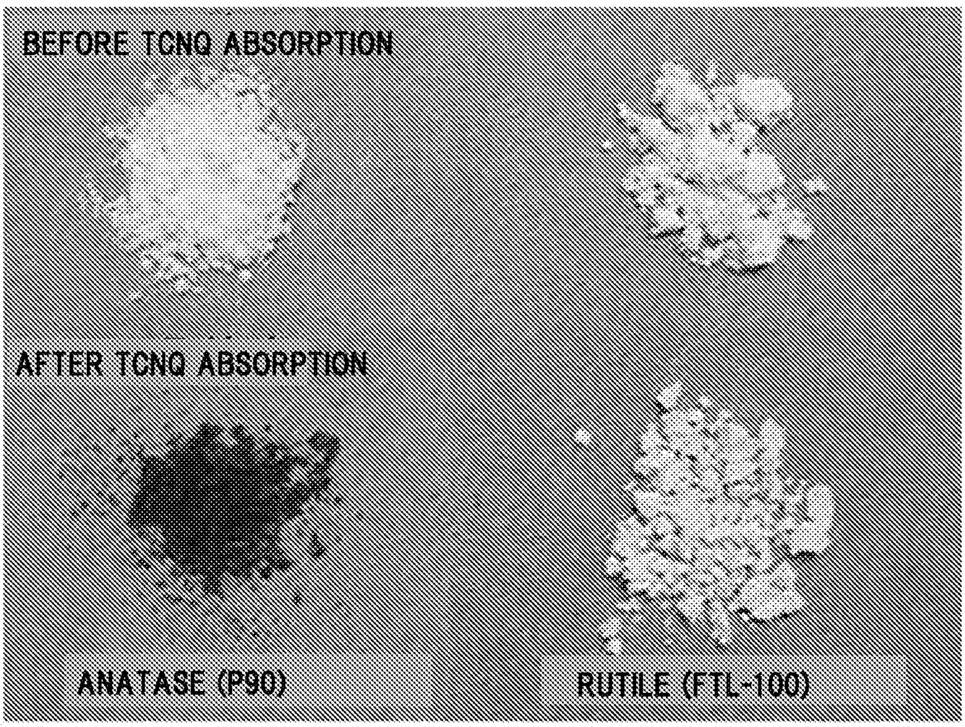
BEFORE TCNQ ABSORPTION
AFTER TCNQ ABSORPTION
ANATASE (P90)
RUTILE (FTL-100)

Fig. 17

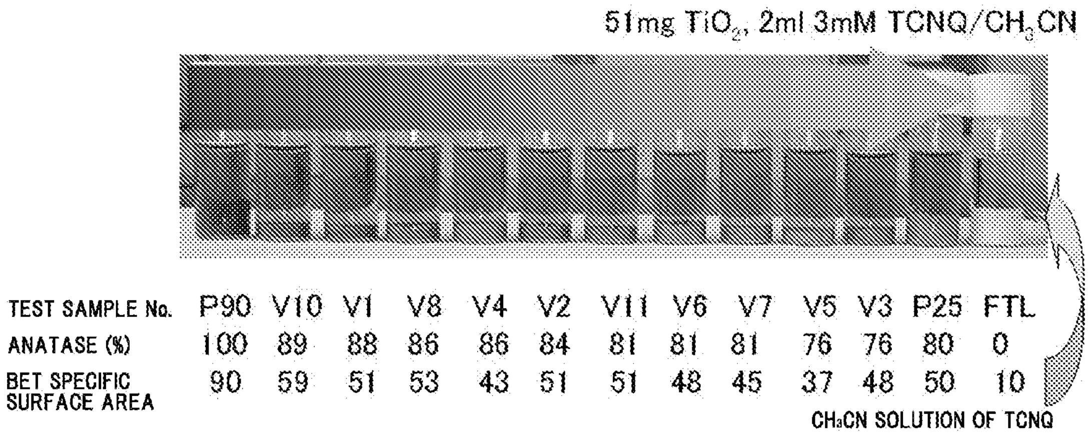
51mg $TiO_2$, 2ml 3mM TCNQ/$CH_3CN$
TEST SAMPLE No. P90 V10 V1 V8 V4 V2 V11 V6 V7 V5 V3 P25 FTL
ANATASE (%) 100 89 88 86 86 84 81 81 81 76 76 80 0
BET SPECIFIC SURFACE AREA 90 59 51 53 43 51 51 48 45 37 48 50 10
$CH_3CN$ SOLUTION OF TCNQ

Fig. 18

**INTERNATIONAL SEARCH REPORT**

International application No.
PCT/JP2009/054345

A. CLASSIFICATION OF SUBJECT MATTER
*H01M14/00*(2006.01)i, *C01G23/04*(2006.01)i, *C09B23/00*(2006.01)i, *C09B57/00*(2006.01)i, *C09B67/02*(2006.01)i, *H01L31/04*(2006.01)i

According to International Patent Classification (IPC) or to both national classification and IPC

B. FIELDS SEARCHED

Minimum documentation searched (classification system followed by classification symbols)
H01M14/00, C01G23/04, C09B23/00, C09B57/00, C09B67/02, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)
CAplus(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| P,X<br>A | Jun'ichi FUJISAWA, Toshiyuki NAGATANI, Yoshitaka SANEHIRA, Jotaro NAKAZAKI, Satoshi UCHIDA, Takaya KUBO, Hiroshi SEGAWA, "TCNE, TCNQ, TCNAQ o Zokanzai ni Mochiita Shikiso Zokan Taiyo Denchi", CSJ: The Chemical Society of Japan Koen Yokoshu, Vol.88th/No.1, 12 March, 2008 (12.03.08), 556, 3 L6-05 | 1-11,13<br>12 |
| X<br>A | JP 2002-110260 A (Toyota Central Research and Development Laboratories, Inc.), 12 April, 2002 (12.04.02), Claim 1; Par. Nos. [0022], [0034], [0076]; examples (Family: none) | 1-9,11,13<br>10,12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 June, 2009 (02.06.09) | 16 June, 2009 (16.06.09) |
| Name and mailing address of the ISA/<br>Japanese Patent Office | Authorized officer |
| Facsimile No. | Telephone No. |

Form PCT/ISA/210 (second sheet) (April 2007)

INTERNATIONAL SEARCH REPORT

International application No.
PCT/JP2009/054345

C (Continuation). DOCUMENTS CONSIDERED TO BE RELEVANT

| Category* | Citation of document, with indication, where appropriate, of the relevant passages | Relevant to claim No. |
|---|---|---|
| X<br>A | Bradley W.Smucker, Joshua M.Hudson, Mohammad A.Omary, and Kim R.Dunbar, Structural, Magnetic, and Optoelectronic Properties of (Diimine)(dithiolato)platinum(II) and -palladium(II) Complexes and Their Charge-Transfer Adducts with Nitrile Acceptors, Inorganic Chemistry, Vol.42,/No.15, 2003.06.21, 4714-4723 | 1-11,13<br>12 |

Form PCT/ISA/210 (continuation of second sheet) (April 2007)

**INTERNATIONAL SEARCH REPORT**

International application No.
PCT/JP2009/054345

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

As disclosed in prior art documents listed below, there exists no special technical feature so linking a group of inventions of claims 1-13 as to form a single general inventive concept.

[Prior Art Document List]

1. JP 2002-110260 A (Toyota Central Research and Development Laboratories, Inc.), 12 April, 2002 (12.04.02), claim 1, paragraphs [0022], [0034], [0076], examples (no patent family members)

2. Bradley W. Smucker, Joshua M. Hudson, Mohammad A. Omary, and Kim R. Dunbar, Structural, Magnetic, and Optoelectronic Properties of (Diimine) (dithiolato) platinum (II) and -palladium(II) (continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

INTERNATIONAL SEARCH REPORT

International application No.
PCT/JP2009/054345

Continuation of Box No.III of continuation of first sheet(2)

Complexes and Their Charge-Transfer Adducts with Nitrile Acceptors, Inorganic Chemistry, Vol.42,/No.15, 21 June, 2003 (21.06.03), 4714-4723

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **B. W. Smucker ; J. M. Hudson ; M. A. Omary ; K. R. Dunbr.** *Inorganic Chemistry,* 2003, vol. 42, 4714